(19) **Europäisches Patentamt**
**European Patent Office**
**Office européen des brevets**

(11) **EP 4 118 692 B1**

(12) **EUROPEAN PATENT SPECIFICATION**

(45) Date of publication and mention
of the grant of the patent:
**19.02.2025 Bulletin 2025/08**

(51) International Patent Classification (IPC):
*H10K 10/00* (2023.01)    *H10K 85/00* (2023.01)
*H10N 50/10* (2023.01)    *H10N 50/85* (2023.01)

(21) Application number: **21767184.1**

(22) Date of filing: **08.03.2021**

(52) Cooperative Patent Classification (CPC):
**H10N 50/10; H10K 10/701; H10K 85/761;
H10N 50/85**

(86) International application number:
**PCT/IL2021/050253**

(87) International publication number:
**WO 2021/181382 (16.09.2021 Gazette 2021/37)**

(54) **METHOD AND SYSTEM FOR SPIN-DEPENDENT CONDUCTION**

VERFAHREN UND SYSTEM FÜR SPINABHÄNGIGE LEITUNG

PROCÉDÉ ET SYSTÈME DE CONDUCTION DÉPENDANT DU SPIN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.03.2020 US 202062986700 P**

(43) Date of publication of application:
**18.01.2023 Bulletin 2023/03**

(73) Proprietors:
• **Ramot at Tel-Aviv University Ltd.
Tel-Aviv 6139201 (IL)**
• **Yeda Research and Development Co. Ltd.
7610002 Rehovot (IL)**
• **Yissum Research Development Company of the
Hebrew University of Jerusalem Ltd.
9139002 Jerusalem (IL)**

(72) Inventors:
• **GAZIT, Ehud
6139201 Tel-Aviv (IL)**
• **NAAMAN, Ron
7610002 Rehovot (IL)**
• **PALTIEL, Yossi
7642717 Rehovot (IL)**
• **YOCHELIS, Shira
7400411 Ness Ziona (IL)**
• **GILEAD, Sharon
6139201 Tel Aviv (IL)**

• **MAKAM, Pandeeswar
6139201 Tel Aviv (IL)**
• **MONDAL, Amit Kumar
7610002 Rehovot (IL)**
• **BROWN, Noam
6139201 Tel Aviv (IL)**
• **GOREN, Naama
7319000 Kibbutz Nachshonim (IL)**

(74) Representative: **Eisenführ Speiser
Patentanwälte Rechtsanwälte PartGmbB
Postfach 31 02 60
80102 München (DE)**

(56) References cited:
**WO-A2-2015/145445    US-A1- 2016 057 859
US-B2- 9 391 285**

• **LU P. H. ET AL: "Spin-dependent charge
transport through 2D chiral hybrid lead-iodide
perovskites", SCIENCE ADVANCES, vol. 5, no.
12, 6 December 2019 (2019-12-06), pages 1 - 8,
XP055879937, Retrieved from the Internet
<URL:https://www.science.
org/doi/pdf/10.1126/sciadv.aay0571> [retrieved
on 20191206]**

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

EP 4 118 692 B1

- PUNZI P ET AL: "Paper;Metal chelates anchored to poly-l-peptides and linear d,l- -peptides with promising nanotechnological applications;Metal chelates anchored to poly-L-peptides and linear D,L-alpha-peptides with promising nanotechnological applications", NANOTECHNOLOGY, INSTITUTE OF PHYSICS PUBLISHING, BRISTOL, GB, vol. 23, no. 39, 12 September 2012 (2012-09-12), pages 395703, XP020230101, ISSN: 0957-4484, DOI: 10.1088/ 0957-4484/23/39/395703
- JINLEI ZHANG ET AL: "Low-magnetic-field controlled magnetodielectric coupling at room temperature in a chiral layered diphenylalanine-based 1D-coordination-polymer", JOURNAL OF PHYSICS D: APPLIED PHYSICS, INSTITUTE OF PHYSICS PUBLISHING, BRISTOL, GB, vol. 53, no. 15, 4 February 2020 (2020-02-04), XP020352464, ISSN: 0022-3727, [retrieved on 20200204], DOI: 10.1088/1361-6463/AB6BED
- AHN JIHOON ET AL: "A new class of chiral semiconductors: chiral-organic-molecule-incorporating organic-inorganic hybrid perovskites", MATER. HORIZ., vol. 4, no. 5, 31 May 2017 (2017-05-31), pages 851 - 856, XP093064908, ISSN: 2051-6347, DOI: 10.1039/ C7MH00197E
- PUNZI P. ET AL.: "Metal chelates anchored to poly-L-peptides and linear D,L-alpha-peptides with promising nanotechnological applications", NANOTECHNOLOGY, vol. 23, no. 39, 12 September 2012 (2012-09-12), pages 1 - 10, XP020230101, DOI: 10.1088/0957-4484/23/39/ 395703
- ECKSHTAIN-LEVI MEITAL, CAPUA EYAL, REFAELY-ABRAMSON SIVAN, SARKAR SOUMYAJIT, GAVRILOV YULIAN, MATHEW SHINTO P., PALTIEL YOSSI, LEV: "Cold denaturation induces inversion of dipole and spin transfer in chiral peptide monolayers", NATURE COMMUNICATIONS, vol. 7, no. 10744, 26 February 2016 (2016-02-26), pages 1 - 9, XP055854540, ISSN: 2041-1723, Retrieved from the Internet <URL:https://doi. org/10.1038/ncomms10744> DOI: 10.1038/ ncomms10744
- MONDAL PRAKASH CHANDRA, ROY PARTHA, KIM DOKYUN, FULLERTON ERIC E., COHEN HAGAI, NAAMAN RON: "Photospintronics: Magnetic Field-Controlled Photoemission and Light- Controlled Spin Transport in Hybrid Chiral Oligopeptide-Nanoparticle Structures", NANO LETTERS, vol. 16, no. 4, 13 April 2016 (2016-04-13), pages 2806 - 2811, XP055854548, ISSN: 1530-6992, Retrieved from the Internet <URL:https://doi.org/10.1021/acs. nanolett.6b00582> DOI: 10.1021/ acs.nanolett.6b00582
- MONDAL AMIT KUMAR, BROWN NOAM, MISHRA SURYAKANT, MAKAM PANDEESWAR, WING DAHVYD, GILEAD SHARON, WIESENFELD YARDEN, LEITUS GREGORY, : "Long-Range Spin-Selective Transport in Chiral Metal-Organic Crystals with Temperature-Activated Magnetization", ACS NANO, vol. 14, no. 12, 22 December 2020 (2020-12-22), pages 16624 - 16633, XP055854553, ISSN: 1936-086X, Retrieved from the Internet <URL:https://doi. org/10.1021/acsnano.0c07569> DOI: 10.1021/ acsnano.0c07569

**EP 4 118 692 B1**

## Description

The project leading to this application has received funding from the European Research Council (ERC) under the European Union's BISON research and innovation project (grant agreement No. 694426).

RELATED APPLICATION

This application claims the benefit of priority of U.S. Provisional Patent Application No. 62/986,700 filed on March 8, 2020.

FIELD AND BACKGROUND OF THE INVENTION

The present invention, in some embodiments thereof, relates to a crystal structure and, more particularly, to a spin-selective conduction structure.

Spintronics refers to the utilization of electron spin to carry out logic and electronic operations. Spintronics allows for harnessing the spin degree of freedom to realize new functionalities while the energy needed for manipulation of the spin is relatively low compared to classical electronics. Chiral-induced spin-selective (CISS) electronic conduction was demonstrated in bio-inspired chiral thin organic films, such as dsDNA, peptides, and proteins.

Organic-molecule-based magnets have been recently studied [Miller, Organic- and Molecule-Based Magnets. Mater. Today 2014, 17, 224-235; Bogani et al., Molecular Spintronics Using Single-Molecule Magnets. Nat. Mater. 2008, 7, 179-186; Sessoli, Magnetic Molecules Back in the Race. Nature 2017, 548, 400-401; Alexandropoulos et al., Chem. Sci. 2019, 10, 1626-1633; Oshio et al., Superparamagnetic Behavior in an Alkoxo-Bridged Iron(II) Cube. J. Am. Chem. Soc. 2000, 122, 12602-12603; Goodwin et al., Molecular Magnetic Hysteresis at 60 K in Dysprosocenium. Nature 2017, 548, 439-4421; Coronado et al., Synthesis, Chirality, and Magnetic Properties of Bimetallic Cyanide-Bridged Two-Dimensional Ferromagnets. Chem. Mater. 2006, 18, 2670-2681; Shiomi et al., An Enantiopair of Organic Ferromagnet Crystals Based on Helical Molecular Packing of Achiral Organic Radicals. J. Phys. Chem. Lett. 2011, 2, 3036-3039; Dhara et al., Possible Room-Temperature Ferromagnetism in Self-Assembled Ensembles of Paramagnetic and Diamagnetic Molecular Semiconductors, J. Phys. Chem. Lett. 2016, 7, 4988-4995; Lu et al., Spin-dependent charge transport through 2D chiral hybrid lead-iodide perovskites. Science Advances, 2019, 5, eaay0571; Punzi et al., Metal chelates anchored to poly-L-peptides and linear D,L-$\alpha$-peptides with promising nanotechnological applications. Nanotechnology, 2012, 23, 395703; Zhang et al., Low-magnetic-field controlled magnetodielectric coupling at room temperature in a chiral layered diphenylalanine-based 1D-coordination-polymer. Journal of Physics D: Applied Physics, 2020, 53, 15LT01; and Dhara et al., Diamagnetic Molecules Exhibiting Room-Temperature Ferromagnetism in Supramolecular Aggregates. J. Phys. Chem. C 2017, 121, 12159-12167]. Such compounds are known to exhibit magnetic properties, useful for spintronic elements and quantum devices.

SUMMARY OF THE INVENTION

According to an aspect of some embodiments of the present invention there is provided a spin-selective conduction structure. The spin-selective conduction structure comprises a crystal having a monolayer of metal atoms between two layers of chiral organic molecules, wherein each metal atom is coupled to two chiral organic molecules, one at each layer, and wherein a chirality of organic molecules in one of the two layers is the same as a chirality of organic molecules in a another one of the two layers.

According to some embodiments of the invention the spin-selective conduction structure wherein a chirality of all of the organic molecules in each layer is the same.

According to some embodiments of the invention the crystal is arranged as a stack comprises a plurality of monolayers of the metal atoms, each monolayer being between two layers of the chiral organic molecules.

According to some embodiments of the invention a thickness of the stack, perpendicular to the monolayer, is at least 100 nm, more preferably at least 150 nm, more preferably at least 200 nm, more preferably at least 250 nm, more preferably at least 300 nm.

According to some embodiments of the invention the metal atoms are selected to reduce quantum de-coherence of spin states.

According to some embodiments of the invention the spin-selective conduction structure is characterized by spin-polarization of at least 20%, more preferably at least 25%, more preferably at least 30%.

According to some embodiments of the invention the chiral organic molecules comprise chiral aromatic molecules.

According to some embodiments of the invention the chiral organic molecules self-assemble to form the layers.

According to some embodiments of the invention the crystal is noncentrosymmetric and is characterized by a

3

space group P2₁.

According to some embodiments of the invention the crystal is noncentrosymmetric and is characterized by a space group P1.

According to some embodiments of the invention the chiral organic molecules comprise chiral amino acid molecules.

According to some embodiments of the invention amino and carboxylic acid moieties of the amino acid molecules are ligands forming the coupling.

According to some embodiments of the invention the chiral amino acid molecules comprise aromatic amino acid molecule.

According to some embodiments of the invention the chiral amino acid molecules comprise D-phenylalanine.

According to some embodiments of the invention the chiral amino acid molecules comprise L-phenylalanine.

According to some embodiments of the invention the chiral amino acid molecules comprise D-pentafluorophenylalanine.

According to some embodiments of the invention the chiral amino acid molecules comprise L-pentafluorophenylalanine.

According to some embodiments of the invention the chiral amino acid molecules comprise D-tryptophan.

According to some embodiments of the invention the chiral amino acid molecules comprise L-tryptophan.

According to some embodiments of the invention the chiral amino acid molecules comprise D-tyrosine.

According to some embodiments of the invention the chiral amino acid molecules comprise L-tyrosine.

According to some embodiments of the invention the chiral organic molecules comprise chiral peptides, less than 10 amino acids in length, more preferably less than 8 amino acids in length, more preferably less than 6 amino acids in length, more preferably less than 4 amino acids in length, *e.g.,* 2 amino acids in length. According to some of these embodiments, each amino acid residue in the peptide features the same chirality (L or D).

According to some embodiments of the invention the chiral organic molecules comprise chiral metabolites.

According to some embodiments of the invention the metal atoms comprise copper atoms.

According to some embodiments of the invention the metal atoms comprise cobalt atoms.

According to some embodiments of the invention the metal atoms comprise nickel atoms.

According to some embodiments of the invention the metal atoms comprise platinum atoms.

According to an aspect of some embodiments of the present invention there is provided a method of generating current. The method comprises applying energy to the spin-selective conduction structure as delineated above and optionally and preferably as further detailed below, so as to generate flow of charge carriers through the structure.

According to an aspect of some embodiments of the present invention there is provided a method of storing information. The method comprises applying energy to the spin-selective conduction structure as delineated above and optionally and preferably as further detailed below, so as to trap electrons at a preselected spin in the structure.

According to some embodiments of the invention the energy is applied by directing electromagnetic radiation to the structure. According to some embodiments of the invention the energy is applied applying voltage to the structure.

According to some embodiments of the invention the spin-selective conduction structure comprises a semiconductor substrate, wherein one of the layers of chiral organic molecules is deposited on the semiconductor substrate.

According to an aspect of some embodiments of the present invention there is provided a method of generating current. The method provides the spin-selective conduction structure as delineated above and optionally and preferably as further detailed below, and generates condition for charge carriers in the semiconductor substrate to travel through the layers of chiral organic molecules.

According to some embodiments of the invention the method exposes the chiral organic molecules to electromagnetic radiation, so as to generate the condition for the charge carriers in the semiconductor substrate to travel through the layers of chiral organic molecules.

According to some embodiments of the invention the method applies voltage to the semiconductor substrate, so as to generate the condition for the charge carriers in the semiconductor substrate to travel through the layers of chiral organic molecules.

According to an aspect of some embodiments of the present invention there is provided a spintronic circuit. The spintronic circuit comprises the spin-selective conduction structure as delineated above, and optionally and preferably as exemplified herein.

According to an aspect of some embodiments of the present invention there is provided a spintronic circuit. The spintronic circuit comprises an active layer on a semiconductor substrate, wherein the active layer comprises a metal-organic chiral crystal characterized by an electrical resistance that reduces in response to a flow of an electrical current therethrough.

According to some embodiments of the invention the spintronic circuit is incorporated in a device selected from the group consisting of a magnetic field sensor, a memristor, a magnetic memory device, a spintronic transistor, a spin filter device, a spin valve, a spin switch, a spin-polarized light emitting diode (LED), a quantum computer, and a data reading head for reading data from magnetic storage medium.

According to some embodiments of the invention the spintronic circuit comprises a source electrode, a drain electrode, a gate electrode, and a magnetic field generator.

According to some embodiments of the invention the spintronic circuit comprises a controller configure to vary a gate voltage applied to the gate electrode, and a magnetic field applied by the magnetic field generator, so as to provide at least three distinct source-drain current states.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. In addition, the materials, methods, and examples are illustrative only and are not intended to be necessarily limiting.

Implementation of the method and/or system of embodiments of the invention can involve performing or completing selected tasks manually, automatically, or a combination thereof. Moreover, according to actual instrumentation and equipment of embodiments of the method and/or system of the invention, several selected tasks could be implemented by hardware, by software or by firmware or by a combination thereof using an operating system.

For example, hardware for performing selected tasks according to embodiments of the invention could be implemented as a chip or a circuit. As software, selected tasks according to embodiments of the invention could be implemented as a plurality of software instructions being executed by a computer using any suitable operating system. In an exemplary embodiment of the invention, one or more tasks according to exemplary embodiments of method and/or system as described herein are performed by a data processor, such as a computing platform for executing a plurality of instructions. Optionally, the data processor includes a volatile memory for storing instructions and/or data and/or a non-volatile storage, for example, a magnetic hard-disk and/or removable media, for storing instructions and/or data. Optionally, a network connection is provided as well. A display and/or a user input device such as a keyboard or mouse are optionally provided as well.

## BRIEF DESCRIPTION OF THE SEVERAL VIEWS OF THE DRAWINGS

Some embodiments of the invention are herein described, by way of example only, with reference to the accompanying drawings and images. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced.

In the drawings:

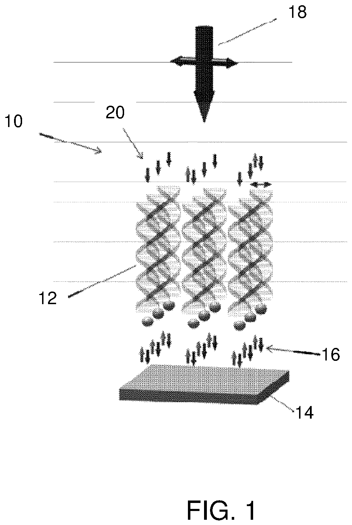

FIG. 1 is a schematic illustration of a spin filter device, which can incorporate a metal-organic chiral crystal according to some embodiments of the present invention.

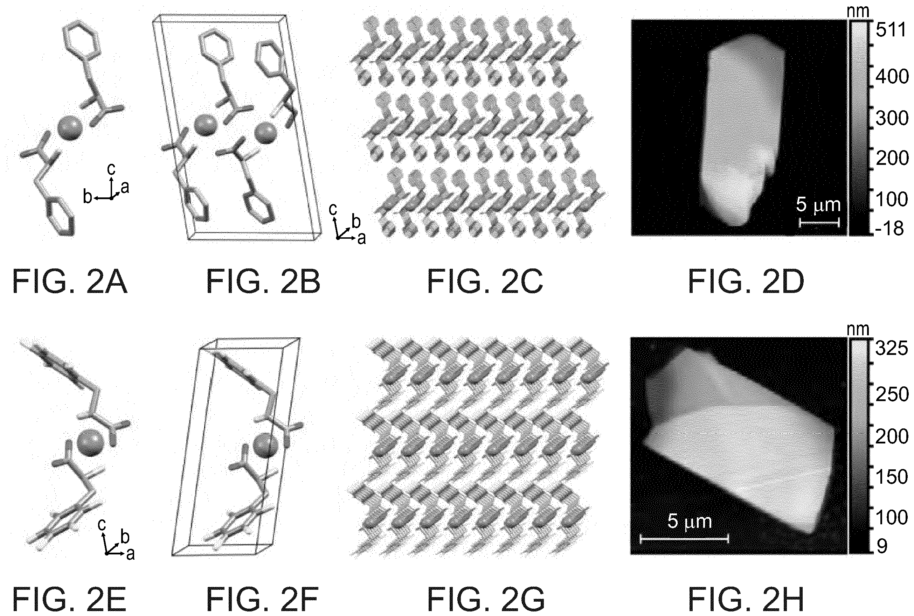

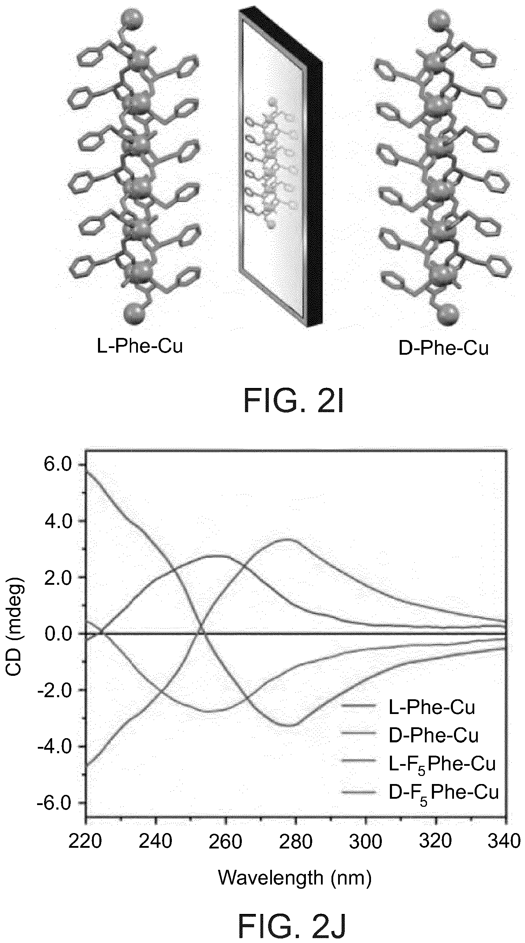

FIGs. 2A-J show structure of the L-Phe-Cu (FIGs. 2A-D) and L-$F_5$Phe-Cu (FIGs. 2E-H) crystals. FIGs. 2A and 2E show respective asymmetric units, FIGs. 2B and 2F show respective unit cells, FIGs. 2C and 2G show respective high-order assembly of the crystal lattice, FIGs. 2D and 2H show respective AFM topography images. The color coding in panels A-H are: carbon, gray; oxygen, red; nitrogen, blue; copper, orange; fluorine, yellow. The chirality of the crystals is shown in FIGs. 2I and 2J, where FIG. 2I illustrates the Phe-Cu mirror symmetry, and FIG. 2J shows CD spectra of the crystals.

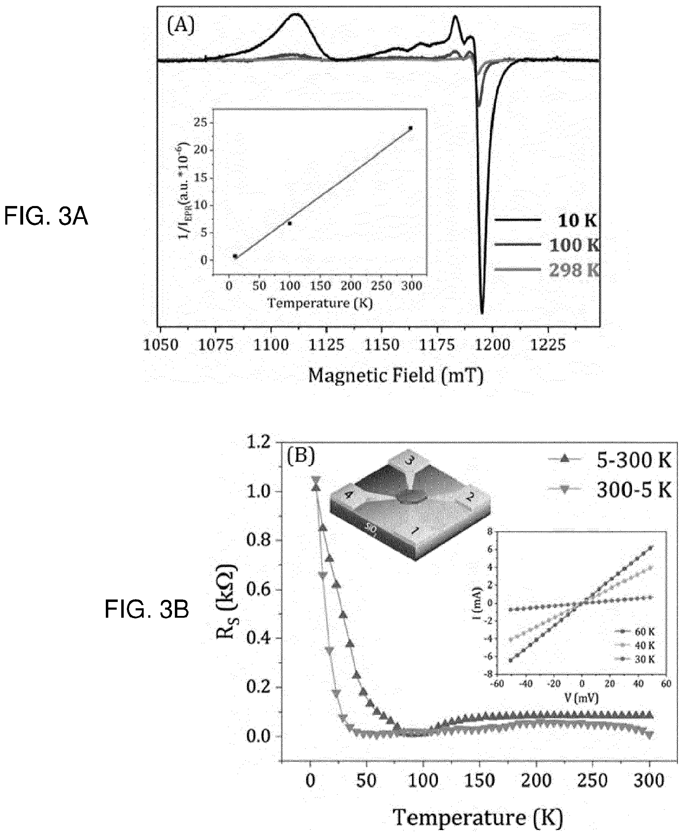

FIGs. 3A and 3B show EPR spectra and surface resistance as a function of temperature. FIG. 3A shows EPR spectra of l-Phe-Cu crystal powder. Inset: Inverse of the EPR integral intensity. FIG. 3B shows surface resistance, RS, measured using a four-point probe (see inset) for decreasing (red) and increasing (blue) temperatures. The current depends linearly on the applied bias (inset on the right) in the range of voltage applied, indicating Ohmic contacts.

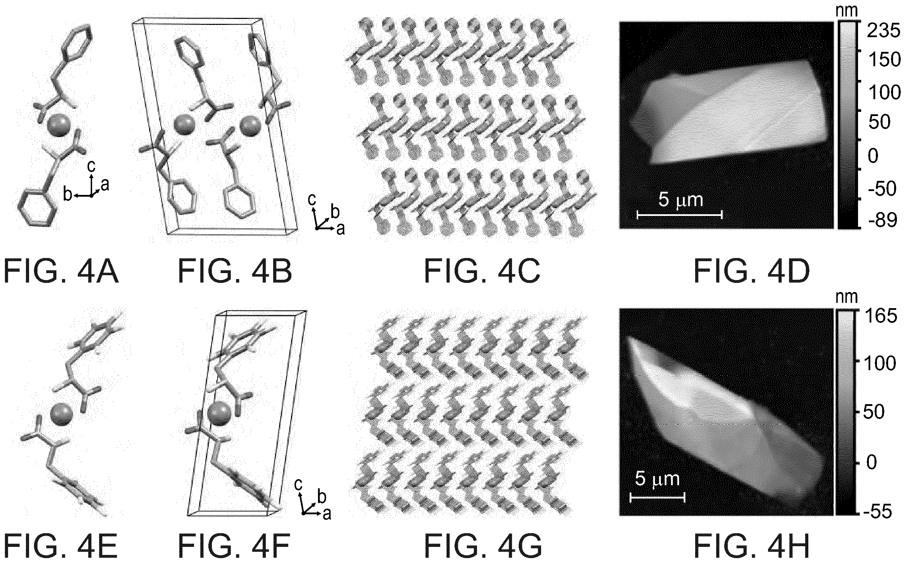

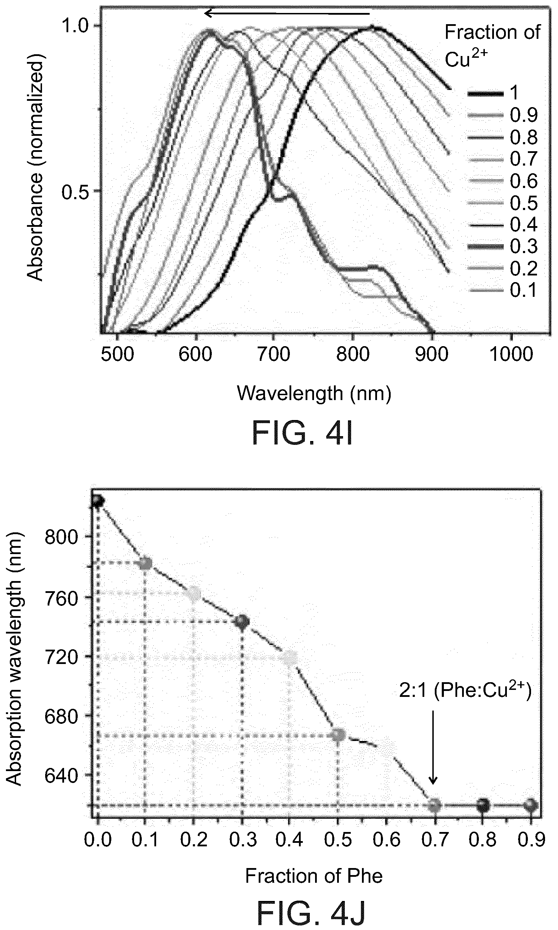

FIGs. 4A-J show structure of the D-Phe-Cu (FIGs. 4A-D) and D-$F_5$Phe-Cu (FIGs. 4E-H) crystals. FIGs. 4A and 4E show respective minimal asymmetric units, FIGs. 4B and 4F show respective unit cells, FIGs. 4C and 4G show respective high-order assembly of the crystal lattice, FIGs. 4D and 4H show respective AFM topography images. FIG. 4I shows UV-visible absorption spectra at different fractions of $Cu^{2+}$ to Phe/ FIG. 4J is a plot of change in absorption wavelength (nm) as a function of the fraction of Phe. The inflection point at a 0.7 Phe fraction, corresponding to a 2:1 (Phe:$Cu^{2+}$) stoichiometry.

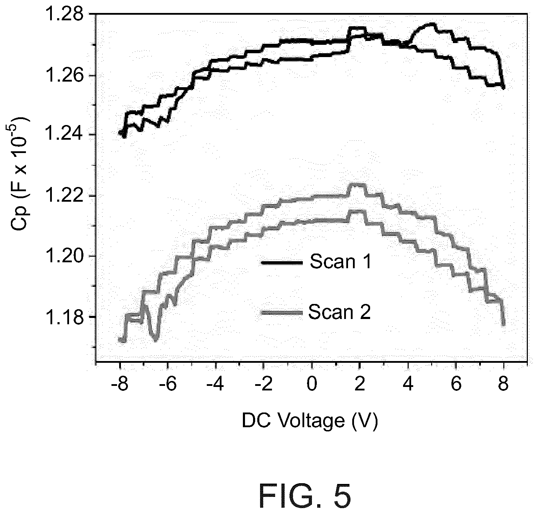

FIG. 5 shows ferroelectric measurements. Shown is a capacitance response as a function of voltage for an L-Phe-Cu crystal at 30 K.

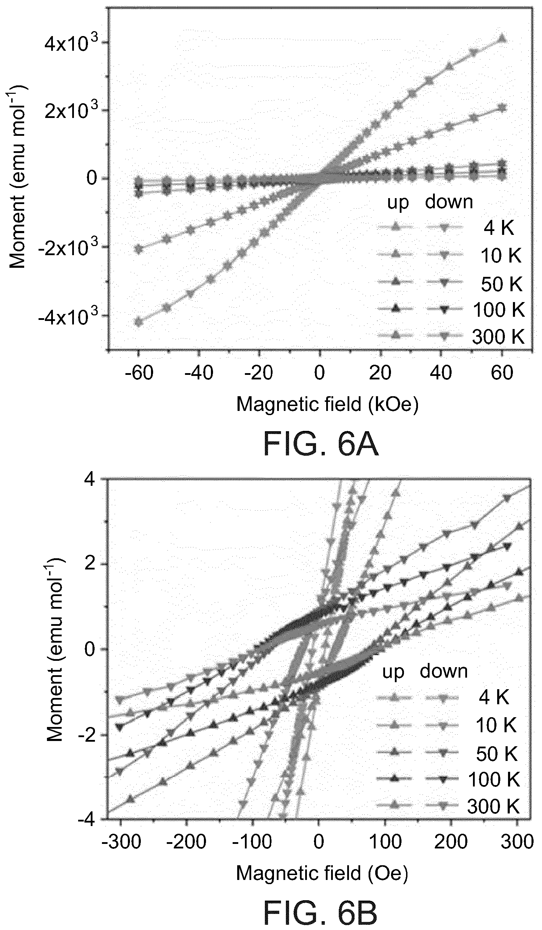

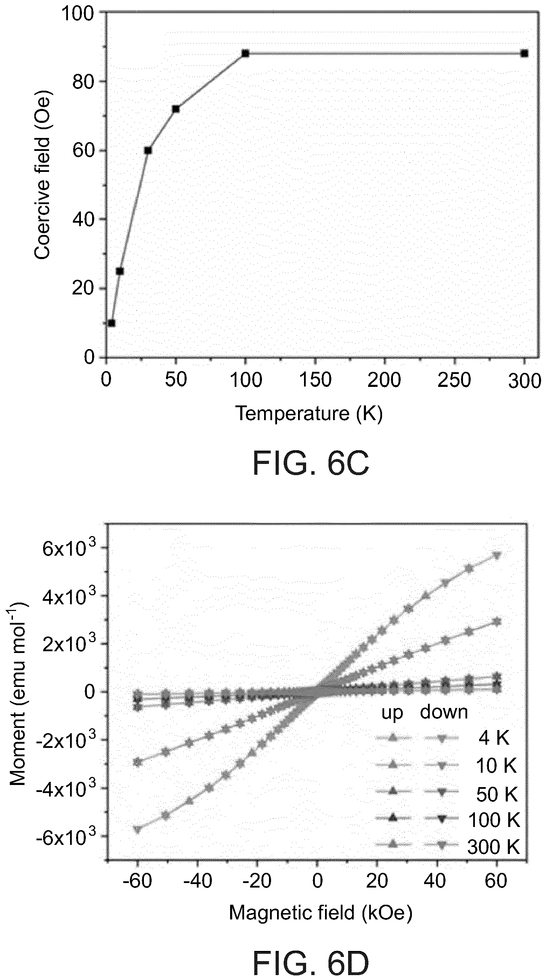

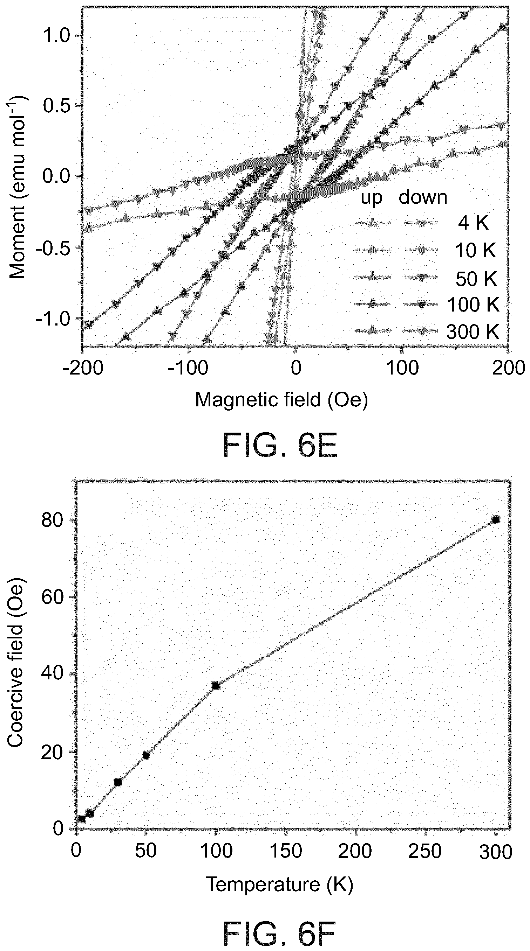

FIG. 6A-F show magnetic properties of L-Phe-Cu crystal, measured parallel (FIGs. 6A-C) and perpendicular (FIGs. 6D-F) to the crystal plane. FIGs. 6A and 6D show full spectrum of the magnetic moment as a function of applied magnetic field. FIGs. 6B and 6E show low-field region of the curves shown in FIGs. 6A and 6D. Note that precision in the magnetic field and moment measurements is, respectively, $\pm 2$ Oe (1 Oe = 79.6 A/m; 1 emu/mol = $4\pi \times 10^{-6}$ m$^3$/mol)

and from about 0.1 to about 1 emu/mol (for low and high field, respectively). The error in the magnetic moment is given by the size of the symbols. The small hysteresis observed at temperatures up to 10 K is below experimental resolution. FIGs. 6C and 6F show coercive field as a function of temperature.

FIGs. 7A-D show magnetic properties of L-Phe-Cu crystal powder. FIG. 7A shows full-spectrum of magnetic moment vs. applied field of L-Phe-Cu crystal powder. FIG. 7B shows low-field region of the magnetic moment dependence on the applied magnetic field. FIG. 7C shows coercive field dependence on temperature. Note that below 5K, the coactivity measured is below the accuracy of the device. FIG. 7D shows magnetic moment as a function of the applied field plot at low temperature (2K) and highest available field (7 Tesla).

FIG. 8A shows Curie-Weiss fitting of L-Phe-Cu crystal powder in a 2 < T < 300 K temperature region measured at 1000 Oe magnetic field.

FIG. 8B shows full-spectrum of magnetic moment as a function of an applied field of D-Phe-Cu crystal powder. Inset: Low-field region of the magnetic moment dependence on the applied magnetic field.

FIG. 8C shows coercive field dependence on temperature in the case of D-Phe-Cu crystals.

FIGs. 9A-D show Curie-Weiss fitting of L-Phe-Cu crystal powder. FIG. 9A shows Curie-Weiss fitting in a 2 < T < 100 K temperature region, showing a negative $\theta$ value. FIG. 9B shows Curie-Weiss fitting in a 100 < T < 300 K region; $\theta$ becomes slightly positive. FIGs. 9C and 9D show Curie-Weiss fitting in a 200 < T < 300 K and 220 < T < 300 K region, respectively.

FIG. 10 shows X-band EPR spectra of L-Phe-Cu crystal powder at different temperatures. Inset: inverse of the EPR integral intensity.

FIG. 11 illustrates a four contact device, fabricated in experiments performed according to some embodiments of the present invention.

FIGs. 12A and 12B illustrate four contact connection schemes, used in experiments performed according to some embodiments of the present invention.

FIG. 13A illustrates an mCP-AFM measurement setup used in experiments performed according to some embodiments of the present invention. A sample (hexagon), about 300 nm in thickness, is placed on a gold-coated Ni surface and contacted from above by a conducting AFM tip. The substrate is magnetized with an external magnetic field of about 200 Oe.

FIGs. 13B and 13C show Room-temperature current-voltage (I-V) measurements of D- and L-Phe-Cu (FIG. 13B) and D- and L-$F_5$Phe-Cu crystals (FIG. 13C), showing spin-selective conduction that depends on enantiomer type, external field direction, and bias polarity. The symbol size represents the measurement error. The measurements were performed at room temperature. Note that spin injected from the substrate is polarized in the opposite direction to the magnetic dipole of the substrate.

FIGs. 14A-D show spin-selective conduction of D/L-Phe-Cu with up/down the external magnetic field. Each line color represents one measurement. Black line represents the average value.

FIGs. 15A-D show spin-selective conduction of D/L-$F_5$Phe-Cu with up/down external magnetic field. Each line color represents one measurement. The black line represents the average value.

FIGs. 16A and 16B show conduction of D/L-Phe-Cu (FIG. 16A) and D/L-$F_5$Phe-Cu (FIG. 16B) without an external magnetic field.

FIGs. 17A and 17B show DFT calculations of L-Phe-Cu. Density of states for the ferromagnetic (FIG. 17A) and antiferromagnetic (FIG. 17B) states.

FIGs. 18A-D show DFT calculations of L-$F_5$Phe-Cu and D-$F_5$Phe-Cu. FIG. 18A shows DOS of the ferromagnetic state of L-$F_5$Phe-Cu, demonstrating states near the fermi energy, which originate mainly from the copper and ligands (nitrogen and oxygen atoms). FIG. 18B shows DOS of the antiferromagnetic state of L-$F_5$Phe-Cu, demonstrating states near the fermi energy, which originate mainly from the copper and ligands (nitrogen and oxygen atoms). FIG. 18C demonstrates DOS of the ferromagnetic state of D-$F_5$Phe-Cu. FIG. 18D shows DOS of the antiferromagnetic state of D-$F_5$Phe-Cu.

FIGs. 19A-F illustrate spin density of L-Phe-Cu ferromagnetic (FIGs. 19A, 19C, 19E) and antiferromagnetic (FIGs. 19B, 19D, 19F) states. FIGs. 19A and 19B are views of b-axis of a unit cell. FIGs. 19C and 19D are view of a-axis of several unit cells. FIGs. 19E and 19F are views of c-axis of several unit cells. Color coding in crystal illustrations: carbon, gray; oxygen, red; nitrogen, blue; copper, brown. The two spin orientations are marked by blue and green iso-surfaces.

FIGs. 20A-J show DFT calculations of the partial density of states (PDOS), for L-Phe-Cu ferromagnetic (FIGs. 20A, 20C, 20E, 20G, 20I) and antiferromagnetic (FIGs. 20B, 20D, 20F, 20H, 20J) states, projected on the different d orbitals of the Cu atom and the valence orbitals of O and N. It is observed that only $d_{xy}$, $d_{yz}$, and $d_{z}2$ orbitals, which hybridize with valence orbitals of the adjacent O and N ligand atoms, contribute to the magnetism-related peak at about 3.6 eV. Positive (negative) values represent up (down) spin PDOS.

FIGs. 21A-E show a structure of the D-phenylalanine-copper crystal. FIG. 21A illustrates a unit-cell and small viewed down the b axis, FIG. 21B illustrates high-order assembly demonstrating the layered structure of the crystal. FIG. 21C illustrates high-order assembly viewed along the c axis. FIG. 21D is a SEM micrograph. FIG. 21E is an optical microscope image.

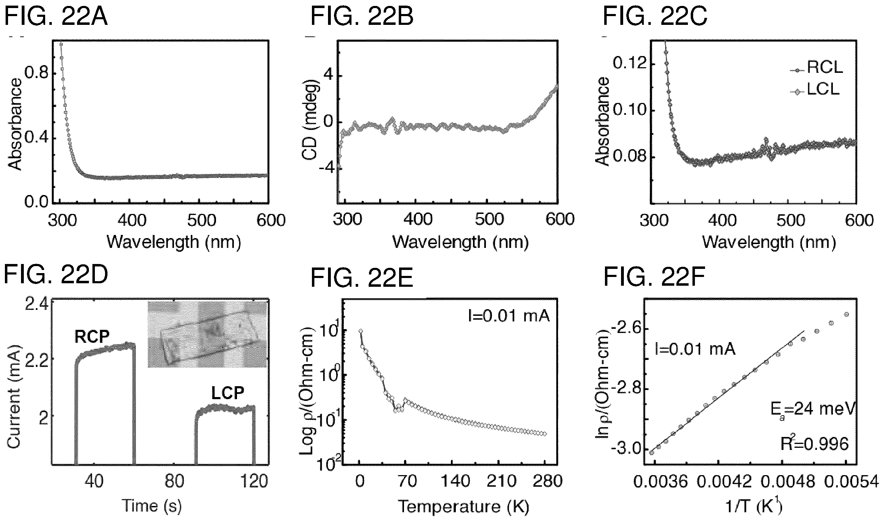

FIGs. 22A-F show crystal optical and electrical properties. FIG. 22A shows the absorption spectrum using linear polarized light. FIG. 22B shows CD spectrum of the crystal. FIG. 22C shows the absorption spectra measured with clockwise (RCL) and counter-clockwise (LCL) circularly polarized light. FIG. 22D shows photocurrent measured at a constant voltage of 5V, for right-handed circular polarized (RCP) and left-handed circular polarized (LCP) light. Inset: The set-up and the optical microscope image of the device with a right-handed chiral MOC crystal placed between two Au pads. FIG. 22E shows the dependence of the resistivity on temperature. FIG. 22F is an Arrhenius plot presenting the resistivity versus the inverse temperature. The Activation energy, $E_a$, is obtained by multiplying the slope by the Boltzmann factor. It corresponds to the band gap in the crystals.

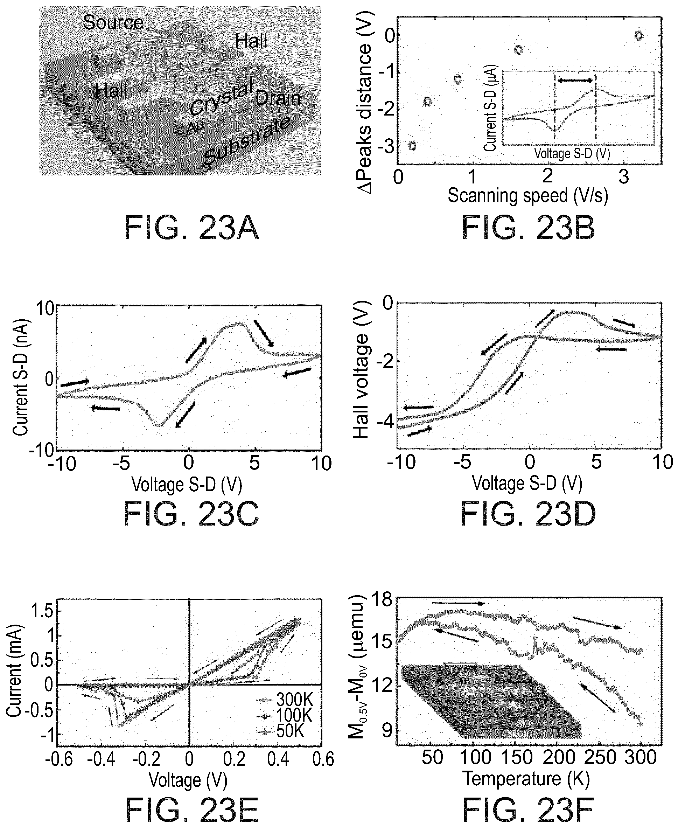

FIGs. 23A-F show memristor characteristics. FIG. 23A illustrates a Hall device used to measure the MOC crystal transport. Six Au contacts were used to measure in parallel the Hall voltage and the drain-source voltage. FIG. 23B shows a dependence on the scanning speed and the distance between the voltage peaks. The distance decreases as the measurement rate rises. The inset shows the drain-source IV curve at room temperature, presenting hysteresis with opposite peaks; the distance between the peaks is denoted by dashed lines and is defined as $\Delta V$ peaks. FIG. 23C is an IV curve with arrows indicating the direction of the voltage sweep. The device differs from the one presented in FIG. 23A, although it shows similar behavior. FIG. 23D shows a Hall voltage demonstrating that asymmetric characterization is dependent on the applied drain-source voltage. FIG. 23E is a current-voltage characteristic curve of the device with a planar electrode configuration at different temperatures. FIG. 23F shows a temperature-dependent magnetic moment of the device. The plots present the magnetic moment measured when a potential of 0.5 V is applied, and the magnetic moment measured at 0V is subtracted.

FIGs. 24A-C show multilevel 6 states for up, down, and no magnetization on a source pad. FIG. 24A illustrates a bottom gate device and a measurement set-up. Permanent magnets were placed along the current direction. FIG. 24B shows current-voltage dependency with two different gate voltages and three different magnetic fields for each gate voltage. Inset: microscope image of the bottom gate device with a crystal placed between the Ni and Au pads. FIG. 24C shows a close-up of a narrow voltage band of the IV curves, as denoted in FIG. 24B, showing the six different double states.

FIG. 25 is a schematic illustration of a spintronic circuit, according to some embodiments of the present invention.

FIG. 26 is a schematic illustration of a spintronic circuit, according to some embodiments of the present invention.

DESCRIPTION OF SPECIFIC EMBODIMENTS OF THE INVENTION

The present invention, in some embodiments thereof, relates to a crystal structure and, more particularly, to a spin-selective conduction structure.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

It was found that due to the quantum-mechanical nature of the CISS effect, quantum de-coherence limits the length- and time-scale of the phenomenon to several tens of nanometers. The present disclosure provides a metal-organic chiral crystal that achieves spin-selective conduction using metal atoms and chiral organic molecules. The crystal conducts current in a spin-selective manner, based on the CISS effect, owing to the chiral environment in conjunction with the conducting metal atoms. The inventors experimentally demonstrated spin-selective conduction over a range that is larger than 200 nm. In some embodiments of the present invention the crystal is characterized by an electrical resistance that decreases in response to a flow of an electrical current therethrough. This is unlike conventional oxide-based devices in which the current applied increases the resistance, since the current fills charge trap states.

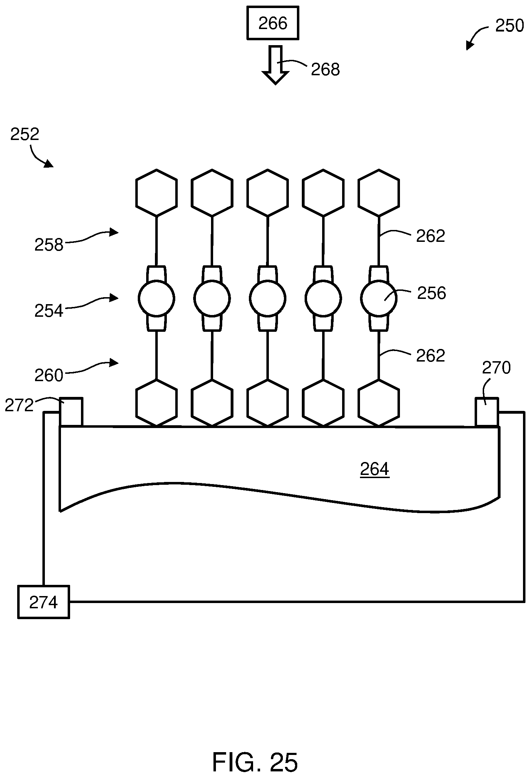

FIG. 25 is a schematic illustration of a spin-selective conduction structure **250,** according to some embodiments of the present invention. The structure comprises a crystal **252** having a monolayer **254** of metal atoms **256** between two layers **258, 260** of chiral organic molecules **262.** Each metal atom is optionally and preferably coupled to two chiral organic molecules **262,** one at each of layers **258** and **260.** The chirality of organic molecule **262** in one of the two layers **258** and **260** is the same as a chirality of organic molecule **262** in the other one of the two layers **258** and **260.**

According to some embodiments of the invention the chiral organic molecules **262** are chiral aromatic molecules.

According to some of any of the embodiments described herein, each of the aromatic molecules comprises an aromatic amino acid.

According to some embodiments of the invention, the chiral organic molecules, e.g., chiral aromatic molecules, self-assemble to form said layers.

By "aromatic molecule" it is meant a molecule (a compound) that comprises at least one aromatic moiety or group.

As used herein, the phrase "aromatic group" or "aromatic moiety" describes a monocyclic or polycyclic moiety having a completely conjugated pi-electron system. The aromatic group can be an all-carbon moiety or can include one or more heteroatoms such as, for example, nitrogen, sulfur or oxygen. The aromatic group can be substituted or unsubstituted, whereby when substituted, the substituent can be, for example, one or more of alkyl, trihaloalkyl, alkenyl, alkynyl, cycloalkyl, aryl, heteroaryl, heteroalicyclic, halo, nitro, azo, hydroxy, alkoxy, thiohydroxy, thioalkoxy, cyano and amine.

Exemplary aromatic groups include, for example, phenyl, biphenyl, naphthalenyl, phenanthrenyl, anthracenyl, [1,10]phenanthrolinyl, indoles, thiophenes, thiazoles and, [2,2']bipyridinyl, each being optionally substituted. Thus, representative examples of aromatic groups that can serve as the side chain within the aromatic amino acid described herein include, without limitation, substituted or unsubstituted naphthalenyl, substituted or unsubstituted phenanthrenyl, substituted or unsubstituted anthracenyl, substituted or unsubstituted [1,10]phenanthrolinyl, substituted or unsubstituted [2,2']bipyridinyl, substituted or unsubstituted biphenyl and substituted or unsubstituted phenyl. The aromatic group can alternatively be substituted or unsubstituted heteroaryl such as, for example, indole, thiophene, imidazole, oxazole, thiazole, pyrazole, pyridine, pyrimidine, quinoline, isoquinoline, quinazoline, quinoxaline, and purine.

In some of any of the embodiments described herein, the aromatic molecule comprises at least one aromatic moiety that is an all-carbon aromatic moiety, e.g., an aryl.

In some of any of the embodiments described herein, the aromatic molecule is or comprises an aromatic amino acid.

In some of any of the embodiments described herein, the aromatic molecule is an aromatic amino acid.

By "aromatic amino acid" it is meant an amino acid, or an amino acid residue in a peptide comprising same, that has an aromatic moiety or group, as defined herein, is its side chain. In exemplary embodiments, an aromatic amino acid has, for example, a substituted or unsubstituted naphthalenyl or a substituted or unsubstituted phenyl, in its side chain. The substituted phenyl may be, for example, pentafluoro phenyl, iodophenyl, biphenyl and nitrophenyl.

According to some embodiments of the invention the chiral organic molecules comprise chiral amino acid molecules. According to some embodiments of the invention the chiral amino acid molecules comprise aromatic amino acid molecule. According to some embodiments of the invention the chiral amino acid molecules comprise D-phenylalanine. According to some embodiments of the invention the chiral amino acid molecules comprise L-phenylalanine. According to some embodiments of the invention the chiral amino acid molecules comprise D-pentafluorophenylalanine. According to some embodiments of the invention the chiral amino acid molecules comprise L-pentafluorophenylalanine. According to some embodiments of the invention the chiral amino acid molecules comprise D-tryptophan. According to some embodiments of the invention the chiral amino acid molecules comprise L-tryptophan. According to some embodiments of the invention the chiral amino acid molecules comprise D-tyrosine. According to some embodiments of the invention the chiral amino acid molecules comprise L-tyrosine.

According to some embodiments of the invention the chiral organic molecules comprise chiral peptides, less than 10 amino acids in length, more preferably less than 8 amino acids in length, more preferably less than 6 amino acids in length, more preferably less than 4 amino acids in length, *e.g.,* 2 amino acids in length. According to some of these embodiments, each amino acid residue in the peptide features the same chirality (L or D). According to some embodiments of the invention the chiral organic molecules comprise chiral metabolites.

According to some embodiments of the invention the amino and carboxylic acid moieties of the amino acid molecules are ligands forming the coupling between the molecules and the metal atoms.

According to some embodiments of the invention the metal atoms **256** are selected to reduce quantum decoherence of spin states. According to some embodiments of the invention the metal atoms **256** comprise copper atoms. According to some embodiments of the invention the metal atoms **256** comprise cobalt atoms. According to some embodiments of the invention the metal atoms **256** comprise nickel atoms. According to some embodiments of the invention the metal atoms **256** comprise platinum atoms.

According to some embodiments of the invention the crystal is characterized by spin-polarization of at least 20%, more preferably at least 25%, more preferably at least 30%.

FIG. 25 illustrates a configuration in which crystal **252** has single monolayer **254** of metal atoms **256** and two layers **258** and **260** of organic molecules **262**. However, this need not necessarily be the case, since, for some applications, it may be desired to have crystal **252** arranged as a stack comprising a plurality of monolayers **254** of the metal atoms **256,** each monolayer **254** being between two layers **258, 260** of the chiral organic molecules **262**. Representative examples of such stacks are illustrated in the Examples section that follows. According to some embodiments of the invention a thickness of the stack, perpendicular to the monolayer, is at least 100 nm, more preferably at least 150 nm, more preferably at least 200 nm, more preferably at least 250 nm, more preferably at least 300 nm.

According to some embodiments of the invention spin-selective conduction structure **250** comprises a semiconductor substrate **264**. One of the layers of the chiral organic molecules **262** is deposited on semiconductor substrate **264**. Substrate **264** can comprise any semiconductor material, such as, but not limited to, an elemental semiconductor of Group IV and various combinations of two or more elements from any of Groups III, IV, V and VI of the periodic table of the elements.

As used herein, the term "group" is given its usual definition as understood by one of ordinary skill in the art. For instance, group III elements include B, Al, Ga, In and Tl; Group IV elements include C, Si, Ge, Sn and Pb; Group V elements include N, P, As, Sb and Bi; and Group VI elements include O, S, Se, Te and Po.

For example, when substrate **264** comprises silicon, substrate **264** can comprises can be a silicon oxide or silicon nitride. Other example include, without limitation, silicon oxynitride, aluminum oxide, aluminum oxynitride, hafnium oxynitride, hafnium aluminum oxide, hafnium silicon oxide, hafnium silicon oxynitride, zirconium silicate, hafnium dioxide and zirconium dioxide and the like.

Other types of substrates that are contemplated for use as substrate **264** include, without limitation, binary III-V semiconductor alloys, such as, but not limited to, InAs, InSb, InP GaSb, GaAs and AlSb, ternary III-V semiconductor alloys such as, but not limited to, InGaAs, InAsSb, InAsP, AlInAs, AlAsSb, GaAsP and InSbP, and quaternary semiconductor alloys such as, but not limited to, GaInAsSb.

Spin-selective conduction structure **250** can be incorporated in a spintronic circuit. According to some embodiments of the invention the spintronic circuit is incorporated in a magnetic field sensor. According to some embodiments of the invention the spintronic circuit is incorporated in a magnetic memory device. According to some embodiments of the invention the spintronic circuit is incorporated in a spintronic transistor. According to some embodiments of the invention the spintronic circuit is incorporated in a spin filter device. According to some embodiments of the invention the spintronic circuit is incorporated in a spin valve. According to some embodiments of the invention the spintronic circuit is incorporated in a spin switch. According to some embodiments of the invention the spintronic circuit is incorporated in a spin-polarized light emitting diode. According to some embodiments of the invention the spintronic circuit is incorporated in a quantum computer. According to some embodiments of the invention the spintronic circuit is incorporated in a data reading head for reading data from magnetic storage medium.

Spin-selective conduction structure **250** can be used for generating current. For example, energy can be applied to structure **250,** to generate flow of charge carriers through the structure.

Spin-selective conduction structure **250** can be used for storing information. For example, energy can be applied to structure **250,** to trap electrons at a preselected spin in the structure.

The energy can be applied, for example, by directing electromagnetic radiation to the structure, or by applying voltage to the structure.

In some embodiments of the present invention conditions are generated for charge carriers in semiconductor substrate **264** to travel through the layers **254, 258, 260** of crystal **252.**

This can be done in more than one way. In some embodiments of the present invention the structure **250** is exposed to electromagnetic radiation, for example, to light. This can be done by means of an electromagnetic radiation source **266,** such as, but not limited to, a light source, configured for generating electromagnetic radiation **268.** In various exemplary embodiments of the invention radiation **268** is monochromatic radiation wherein the wavelength of radiation **268** is selected to generate the condition for charge carriers in semiconductor substrate **264** to travel through the layers **254, 258, 260.**

In some embodiments of the present invention voltage is applied to the semiconductor substrate **264** by means of a source electrode **270** and a drain electrode **272,** connected to a voltage source **274,** as to generate the condition for the charge carriers in the semiconductor substrate to travel through the layers of chiral organic molecules **254, 258, 260.**

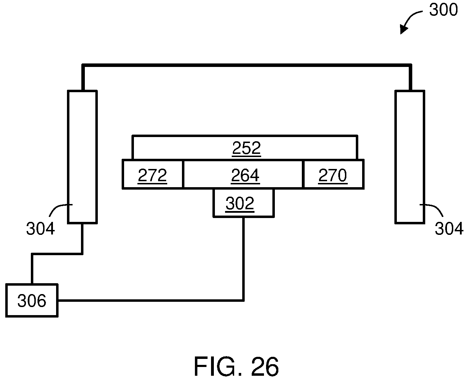

A representative example of a spintronic circuit **300,** according to some embodiments of the present invention is illustrated in FIG. 26. In these embodiments, the spintronic circuit **300** can be used as a memristor.

The term "memristor" is short for "memory resistor." A memristor is a nonlinear component combines a persistent memory with electrical resistance. In other words, a memristor has a non-linear resistance that can act as a universal memory that enables logic operations. The memristor of the present embodiments acts differently from known oxide-based inorganic memristors. In particular, the memristor of the present embodiments comprises a crystal, such as, but not limited to, crystal **252,** that is characterized by an electrical resistance that decreases in response to a flow of an electrical current therethrough. This is unlike conventional -based inorganic memristors in which the current applied increases the resistance, since the current fills charge trap states.

Spintronic circuit **300** comprises an active crystal, such as, but not limited to, crystal **252** on substrate **264,** source electrode **270,** and drain electrode **272.** In some embodiments of the present invention circuit **300** also comprises a gate electrode **302** for applying a gate voltage to substrate **264,** and optionally and preferably also a magnetic field generator **304** for applying a magnetic field to crystal **252.** Preferably, but not necessarily, the magnetic field lines are generally parallel to the source-drain direction defined between source electrode **270** and drain electrode **272.** The Inventors found that such a configuration allows memristor **300** to exhibit multilevel memory states. In particular, it was found that different directions of the magnetic fields, and different gate voltages induce different memory states in memristor **300.** Thus, a controller **306** is optionally and preferably configure to vary the gate voltage applied to gate electrode **306,** and the magnetic field applied by magnetic field generator **304,** so as to provide a plurality (*e.g.*, three or more) distinct memory states. As demonstrated in the Examples section that follows, the Inventors successfully fabricated a memristor that exhibits six memory states using two levels for the gate voltage and three different magnetic field characteristics.

As used herein the term "about" refers to ± 10 %.

The terms "comprises", "comprising", "includes", "including", "having" and their conjugates mean "including but not limited to".

The term "consisting of" means "including and limited to".

The term "consisting essentially of" means that the composition, method or structure may include additional ingredients, steps and/or parts, but only if the additional ingredients, steps and/or parts do not materially alter the basic and novel characteristics of the claimed composition, method or structure.

As used herein, the singular form "a", "an" and "the" include plural references unless the context clearly dictates otherwise. For example, the term "a compound" or "at least one compound" may include a plurality of compounds, including mixtures thereof.

Throughout this application, various embodiments of this invention may be presented in a range format. It should be understood that the description in range format is merely for convenience and brevity and should not be construed as an inflexible limitation on the scope of the invention. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals therebetween.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable subcombination or as suitable in any other described embodiment of the invention. Certain features described in the context of various embodiments are not to be considered essential features of those embodiments, unless the embodiment is inoperative without those elements.

Various embodiments and aspects of the present invention as delineated hereinabove and as claimed in the claims section below find experimental support in the following examples.

EXAMPLES

Reference is now made to the following examples, which together with the above descriptions illustrate some embodiments of the invention in a non limiting fashion.

Utilization of thiolated double stranded DNA (dsDNA) as a spin-selective component in a spin filter device **10** is illustrated FIG. 1, and described in U.S. Patent No. 9,391,285. The thiolated dsDNA is bound to a gold surface **14,** and forms a self-assembled mono-layer 12 of chiral molecules. Unpolarised electrons **16** ejected from the gold surface produced by linearly polarised light **18** incident from the monolayer side are transmitted and can be analyzed. Most of the electrons **20** transmitted through the monolayer 12 are spin polarised. Spin orientation depends on the enantiomer used in the monolayer. The dephasing limits CISS conduction. For example, in some embodiments of the present invention the dephasing limits the CISS conduction several tens of nm.

*Example 1*

*Exemplified Spin-Selective Conduction Structure*

This Example describes a particular bioinspired class of a metal-organic chiral crystals comprising Cu(II) atoms arranged in two-dimensional (2D) layers of D- or L-enantiomers of phenylalanine or pentafluorophenylalanine. This Example shows experimental observation of a thermally activated ferromagnetic component, occurring at temperatures higher than about 50 K. This makes the materials potentially weakly multi-ferroic, that is, possessing a combination of ferroelectric and ferromagnetic properties. Such behavior has, to date, been identified at room temperature only in inorganic materials. The onset of ferromagnetism is accompanied by a significant increase in long-range (above 300 nm), spin-selective electron conduction. Without wishing to be bound to any particular theory, the Inventors, based on electron paramagnetic resonance (EPR) studies and density functional theory (DFT) calculations, attribute the unexpected magnetic behavior to an indirect exchange interaction between the Cu(II) ions through the chiral lattice. It is expected that the discovered combination of chirality and magnetic properties, exists also in other chiral metal-organic crystals, and can also be used in spin-based devices.

In an exemplified embodiment of the present invention, the spin-selective conduction structure comprises bio-inspired self-assembled organometallic crystals formed by D- or L-phenylalanine and with copper (D/L-Phe-Cu, respectively) and/or D- or L-pentafluorophenylalanine with copper (D/L-$F_5$Phe-Cu, respectively). In experiments performed by Inventors of the present invention, these materials self-assembled in water into a structure in which two chiral amino acid molecules coordinate a copper (II) ion. This formed a crystalline structure made up of a continuous layer of copper atoms sandwiched between the chiral amino acid environment.

It was experimentally found that the Phe-Cu and $F_5$Phe-Cu crystallized into noncentrosymmetric crystal structures, where D- and L-Phe-Cu are mirror images of each other and D- and L-$F_5$Phe-Cu are non-symmetric. These crystals are plate-like, with a diameter ranging from 500 nm to 1 mm in diameter, proving relatively simple to use in nano-, micro- and macro-sized applications.

It was experimentally found that the formed crystals conduct current in a spin-selective manner, based on the CISS effect, owing to the chiral amino acid environment in conjunction with the conducting metallic centers. The inventors demonstrated spin-selective conduction for long ranges (more than 200 nm) with good spin-polarization values of about 30%.

## Methods

### Metal-Organic Crystal Preparation

All materials were purchased from Sigma-Aldrich (Israel) unless noted otherwise. Pentafluorophenylalanine was purchased from Chem Impex (USA). All amino acid-copper crystals were obtained using the following general method: 1 equiv of the CuCl2 (99.999% CuCl2 purity, 5 mM) aqueous solution was slowly added to 2 equiv of an amino acid (10 mM) alkaline solution containing 2 equiv of NaOH (10 mM) under heating at 60 °C. Spontaneously, plate-like blue crystals started growing at the liquid-air interface. The crystals were filtered off, washed with deionized water, and dried under vacuum.

### X-ray Crystallography

Blue plate-like crystals suitable for diffraction were coated with Paratone oil (Hampton Research) and mounted on a MiTeGen loops and flash frozen in liquid nitrogen. All X-ray diffraction measurements were done at 100 K. Diffraction measurements for L-Phe-Cu were done at ESRF synchrotron, station ID23-1. Data were collected and processed using MXCube and the automated XDS pipeline. Data for D-Phe-Cu were measured in-house on a Bruker ApexKappaII. Data were collected and processed using the Bruker Apex2 software suite. D/L-$F_5$Phe-Cu crystals were measured in-house on a Rigaku XtaLab[Pro] full Kappa diffractometer. Data were collected and processed with CrysAlis[Pro]. All structures were solved by direct methods using SHELXT-2013 or SHELXT 2016/4. The structures were refined by full-matrix least-squares against $F^2$ with SHELXL 2016/4. The crystallographic data are given in Table 1, below. The structure was illustrated using Mercury 3.9 (Cambridge Crystallographic Data Centre, Cambridge, UK).

Table 1

| Crystallographic data | | | | |
|---|---|---|---|---|
| Compound | L-Phe-Cu | D-Phe-Cu | L-$F_5$Phe-Cu | D-$F_5$Phe-Cu |
| CCDC | 1871975 | 1871971 | 1871972 | 1871973 |
| Diffractometer | ESRF ID23-1 | Bruker KappaApexII | Rigaku XtaLabPro | Rigaku XtaLabPro |
| Empirical formula | $C_{18}H_{20}CuN_2O_4$ | $C_{18}H_{20}CuN_2O_4$ | $C_{18}H_{14}CuF_{10}N_2O_6$ | $C_{18}H_{14}CuF_{10}N_2O_6$ |
| Formula weight (g/mol) | 391.90 | 391.90 | 607.85 | 607.85 |
| Crystal description | Blue plate | Blue plate | Blue plate | Blue plate |
| Temp. (K) | 100 | 100 | 100 | 100 |
| Wavelength | 0.70 | 0.71073 | 0.71073 | 0.71073 |
| (Å) | | | | |
| Crystal system | Monoclinic | Monoclinic | Triclinic | Triclinic |
| Space group | $P2_1$ | $P2_1$ | P1 | P1 |
| a (Å) | 9.4800(19) | 9.4540(18) | 5.56137(13) | 5.55855(12) |

(continued)

| Crystallographic data | | | | |
|---|---|---|---|---|
| Compound | L-Phe-Cu | D-Phe-Cu | L-F$_5$Phe-Cu | D-F$_5$Phe-Cu |
| b (A) | 5.1500(10) | 5.1508(10) | 7.00144(18) | 7.00343(15) |
| c (Å) | 16.670(3) | 16.662(3) | 13.8993(3) | 13.8779(3) |
| $\alpha$ (°) | 90 | 90 | 88.590(2) | 88.5272(19) |
| $\beta$ (°) | 98.93(3) | 99.199(6) | 82.4451(19) | 82.5082(19) |
| $\gamma$ (°) | 90 | 90 | 73.562(2) | 73.5373(19) |
| Volume (Å$^3$) | 804.0(3) | 801.0(3) | 514.53(2) | 513.64(2) |
| Z | 2 | 2 | 1 | 1 |
| Density calculated (mg/m$^3$) | 1.619 | 1.625 | 1.962 | 1.965 |
| Absorption coefficient (mm$^{-1}$) | 1.385 | 1.391 | 1.194 | 1.196 |
| F(000) | 406 | 406.0 | 303 | 303 |
| Crystal size (mm) | 0.15×0.1×0.01 | 0.12×0.1×0.002 | 0.112×0.097×0.03 | 0.22×0.22×0.05 |
| Theta range for data collection (°) | 1.218 to 31.926 | 2.182 to 26.365 | 3.853 to 30.630 | 3.854 to 33.480 |
| Reflections collected (unique) | 9071(5472) | 8796(3281) | 20203(5323) | 26978(6968) |
| R int | 0.0435 | 0.0753 | 0.0351 | 0.0379 |
| Complete ness (%) | 95.3 | 99.7 | 89.7 | 99.7 |
| Data\ restraints\ parameters | 5472/1/242 | 3281/19/239 | 5323/3/343 | 6968/3/338 |
| Goodness-of-fit on F$^2$ | 1.105 | 0.976 | 1.008 | 1.024 |
| Final R [I>2$\sigma$(I)] | R1=0.0462, wR2=0.1234 | R1=0.0505, wR2=0.0819 | R1=0.0231, wR2=0.0569 | R1=0.0298, wR2=0.0722 |
| R (all data) | R1=0.0475, wR2=0.1256 | R1=0.0814 wR2=0.0908 | R1=0.0239, wR2=0.0573 | R1=0.0313, wR2=0.07293 |
| Largest diff. peak and hole (e· Å$^{-3}$) | 1.416 and -0.548 | 0.648 and -0.783 | 0.368 and -0.279 | 0.535 and -0.541 |

*Circular Dichroism Spectroscopy*

CD spectra were obtained at 25 °C using an Applied Photophysics Chirascan CD spectrometer, equipped with a temperature-controlled cell, at 1 nm resolution, as an average of three measurements. Spectra were subtracted and smoothed using the Pro-Data software (Applied Photophysics).

*Ferroelectric Measurements*

A common way to identify ferroelectricity in a material is by measuring the change of the permittivity as a function of an applied electric field ($\varepsilon$-E) or the equivalent capacitance versus applied voltage (C-V) curves. The $\varepsilon$-E or C-V measurements are typically done by applying simultaneously on the sample a variable DC voltage and a constant small AC voltage of relatively high frequency (1 kHz or above). The AC voltage is used to measure the capacitance, which is then plotted as a function of the DC bias field or voltage. In this example, the C-V curve of L-Phe-Cu crystals was measured using an impedance analyzer (Alpha; Novocontrol) at 1 kHz AC frequency.

*Superconducting Quantum Interference Device Measurements*

Magnetic measurements of L-Phe-Cu crystal were performed using MPMS3 SQUID magnetometer (LOT-Quantum Design Inc.) by applying a vibrating sample mode. The sample was placed in a standard brass holder. The temperature dependence of the magnetic moment was taken at FCH mode: the sample was cooled to 2 K under a 1000 Oe magnetic field. Samples were measured while heating from 2 to 300 K. Magnetic field dependencies were taken at different temperatures in the intervals while the magnetic field H was decreased and increased in the range -20 kOe $\leq$ H $\leq$ + 20 kOe (at some cases the interval was lengthened: $\pm$ 60 kOe). The lamellar shape of the crystals before their grinding completely corresponds to the orientation of the layers in the crystal structures (FIGs. 2A-J). This allowed us to measure the difference in magnetic properties with the applied magnetic field oriented perpendicular and parallel to the plane crystal layers (plane *ab*).

*Electron Paramagnetic Resonance Measurements*

CW-EPR spectra were recorded on a Bruker Elexsys E580 spectrometer operating at X-band (9.5 GHz) and Q-band (35 GHz) frequencies and outfitted with an EN4118X-MD4 resonator for X-band measurements and with an EN-5107-D2 for Q-band measurements. The temperature was controlled by an Oxford Instruments CF935 continuous flow cryostat using liquid He. Experimental conditions were 2000 points, with a microwave power of 2 mW, 0.1 mT modulation amplitude, and 100 kHz modulation frequency for X-band measurements. The sweep range was 200 mT. For Q-band measurements, the experimental conditions were 2000 points, with microwave power of 1.6 mW, 0.1 mT modulation amplitude and 50 kHz modulation frequency. The sweep range was 200 mT.

*Four-Point Conduction Device Fabrication*

Gold electrodes, 3 $\mu$m apart from each other, were fabricated in a van der Pauw geometry on a thermal oxide (SiO$_2$-100 nm) p-type silicon wafer.

*Four-Point Conduction Measurements*

With reference to FIG. 3B (top left inset), in the first measurement, a 100 $\mu$A current was applied between electrodes 1 and 2 (I$_{12}$), and the voltage difference was measured between electrodes 3 and 4 (V$_{43}$), producing the resistance R$_A$ (V$_{43}$/I$_{12}$). In the second measurement, the same current was passed between electrodes 2 and 3 (I$_{23}$), and the voltage was measured between electrodes 4 and 1 (V$_{14}$), producing the resistance R$_B$ (V$_{14}$/I$_{23}$). The sample resistance (R$_S$) was calculated the using the formula:

$$\exp\left(\frac{-\pi R_A}{R_S}\right) + \exp\left(\frac{-\pi R_B}{R_S}\right) = 1$$

.

*Magnetic Conductive Probe Atomic Force Microscopy Sample Preparation*

Substrate surfaces were prepared by sputtering a 120 nm layer of nickel, followed by an 8 nm layer of gold on top of a silicon wafer with a 2 $\mu$m thermal silicon oxide layer, with an 8 nm titanium layer for adhesion. The use of the Ni/Au surfaces for the mAFM measurements allowed magnetic-field-induced spin polarization of the electrons injected from the surface to the crystal. All surfaces were cleaned by boiling first in acetone and then in ethanol for 10 min, followed by a UV-ozone cleaning for 15 min and a final incubation in warm ethanol for 40 min. The solution of the crystal was drop-casted on the surface and kept in *vacuo* for evaporation. FIGs. 4A-J present the shape of the crystals and their structure.

*CISS Effect Measurement Using Magnetic Conductive Probe Atomic Force Microscopy*

Magnetic-field-dependent current versus voltage (I-V) characteristics of the crystals were obtained using a multimode magnetic scanning probe microscopy system built with Beetle Ambient AFM and an electromagnet equipped with a R9 electronics controller (RHK Technology). Voltage spectroscopy for I-V measurements were performed by applying voltage ramps with a Pt tip (DPE-XSC11, $\mu$masch with spring constant 3-5.6 N m$^{-1}$) in contact with the sample at an applied force of 5 nN. At least 100 I-V curves were scanned for both magnetic field orientation (field UP and DOWN). The crystals were deposited on a gold-coated nickel (Ni 120 nm, Au 8 nm) silicon substrate. The magnetization direction of the nickel layer (up or down) was controlled by an external magnetic field, oriented perpendicular to the Ni plane.

*Density Functional Theory Calculations*

Geometric structure optimizations and electronic structure calculations were performed using the Vienna *ab Initio* Simulation Package plane wave basis code. Crystal geometric optimizations were performed for the ferromagnetic and antiferromagnetic states separately using the Perdew-Burke-Ernzerhof generalized-gradient approximation exchange- correlation functional, augmented by Tkatchenko-Scheffler van der Waals (TS-vdW) dispersion corrections. Ionic cores were addressed by the projector augmented wave method. The Brillouin zones of all examined crystals were sampled using a Monkhorst-Pack k-point grid of $3 \times 5 \times 3$, with a plane wave energy cutoff of 600 eV, following convergence tests with respect to both parameters. For electronic structure calculations, the screened-hybrid functional of Heyd, Scuseria, and Ernzerhof was used. These methods were found to produce reliable results in molecular crystalline materials. Magnetization was calculated by subtracting the up and down spin densities of the crystal and illustrated using the VESTA software.

## Results and Discussion

D- and L-enantiomers of phenylalanine and pentafluorophenylalanine were separately crystallized with copper ions (D/L-Phe-Cu and D/L-$F_5$Phe-Cu, respectively) and characterized by X-ray crystallography and circular dichroism (CD) spectroscopy (see the Methods section for details). The asymmetric units of both types of crystals comprise an amino acid dimer coordinating a copper atom (FIGs. 2A and 2E, see also FIGs. 4A and 4E, and Table 1 for crystallographic data), where the amino and carboxylic acid moieties of the amino acids act as ligands. The unit cells (see FIGs. 2B and 2F, FIGs. 4B and 4F) assemble to form a layered crystal structure containing an ordered layer of copper atoms, sandwiched between the chiral environment consisting of the amino acids (see FIGs. 2C and 2G, FIGs. 4C and 4G). The Phe-Cu and $F_5$Phe-Cu crystals arrange into noncentrosymmetric space groups, $P2_1$ and $P_1$, respectively. The shape of the crystals is shown in FIGs. 2D and 2H. The L and D unit cells and crystal structures are mirror images of each other (FIG. 2I). CD spectroscopy was used to confirm the chirality of the crystals, showing opposite CD absorption spectra of the two enantiomers (FIG. 2J). The main absorption band of Phe-Cu is located at 254-295 nm, showing a positive (negative) Cotton effect for the D-Phe-Cu (L-Phe-Cu) crystal. $F_5$Phe-Cu has a main absorption band at 230-280 nm, with a positive (negative) Cotton effect for the D-$F_5$Phe-Cu (L-$F_5$Phe-Cu) enantiomer. UV-vis characterization, along with determination of the stoichiometric content of the Cu ions, is provided in FIGs. 4I and 4J.

The ferroelectric response of the crystals was examined. The equivalent capacitance versus applied voltage (C-V) curves of L-Phe-Cu crystals using an impedance analyzer at a frequency of 1 kHz. At very low temperature, 2 K, the samples behave as a perfect capacitor, showing no maximum in the capacitance with the applied DC voltage. At 30 K (FIG. 5), the C-V curve exhibits several peaks in the capacitance, similar to the curve of multidomain ferroelectric materials. After a few cycles, the capacitance drops and the C-V curve stabilizes, becoming smoother with only two peaks near zero voltage, which implies that the coercive field of this material is relatively small. Above about 50 K, the samples behave as conductors, precluding the measurement of capacitance.

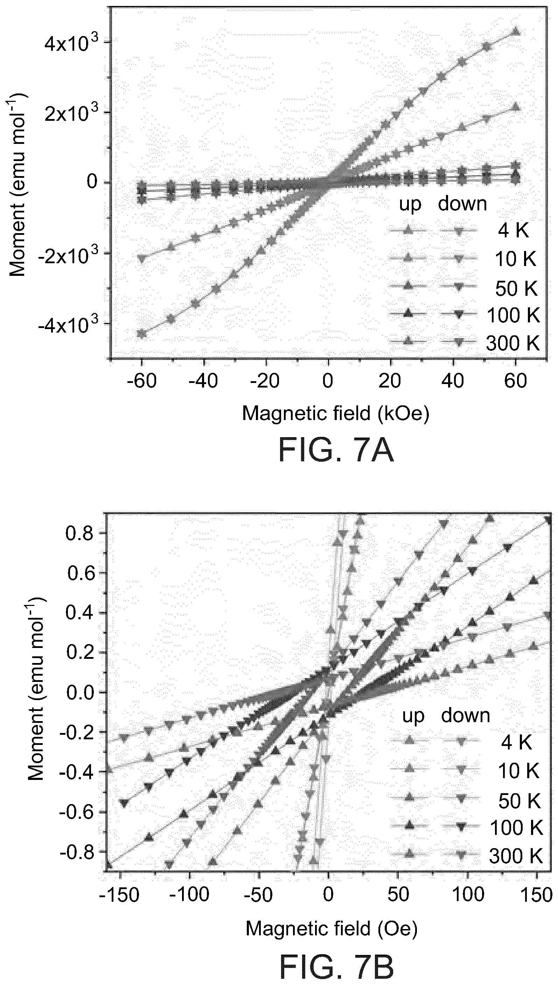

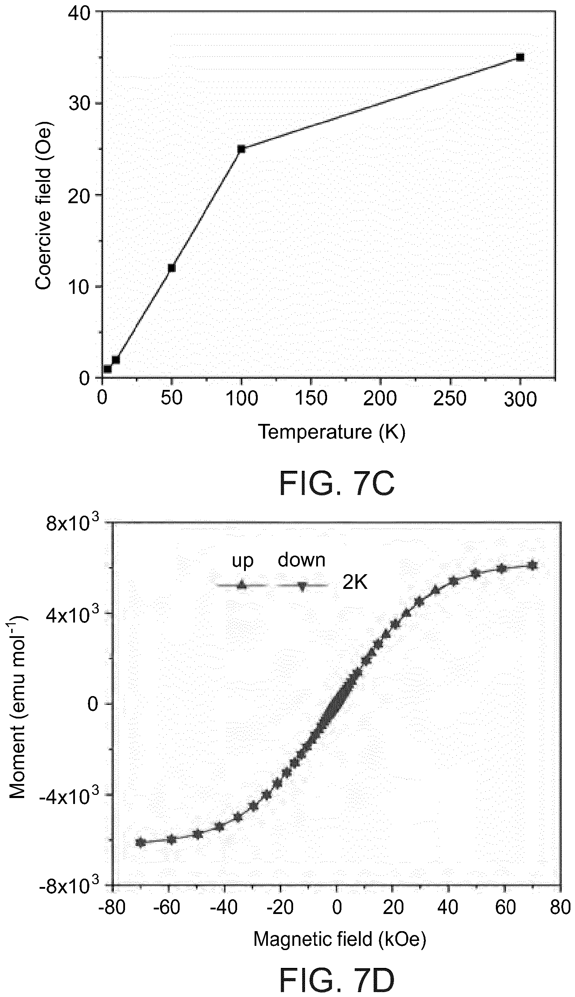

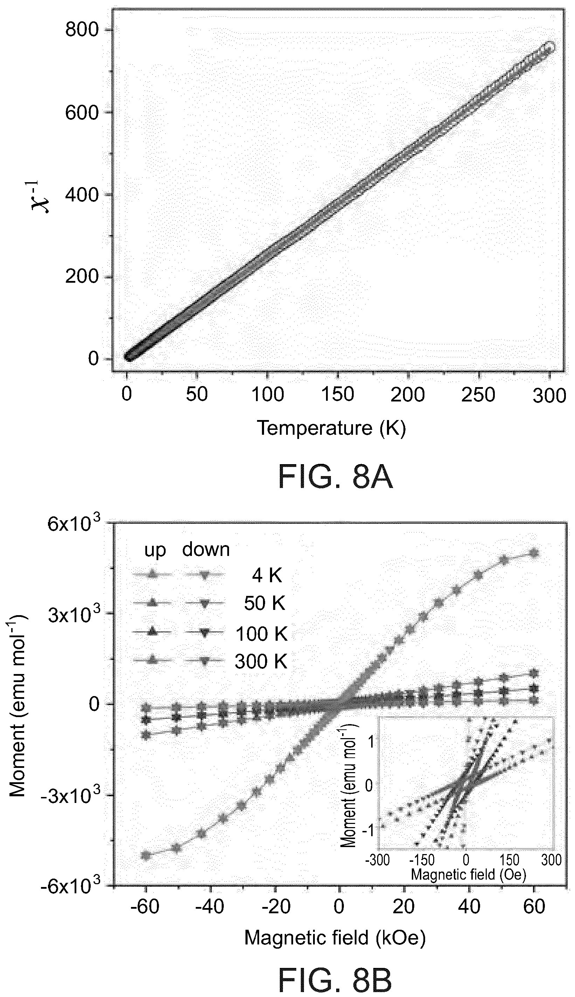

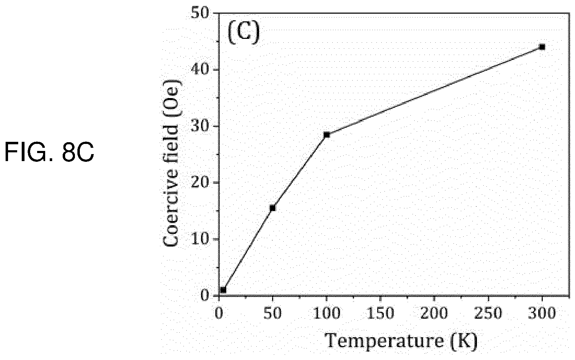

Magnetic properties of these materials were measured using a superconducting quantum interference device (SQUID). The inventors used ultrapure materials for the crystallization and repeated the measurements for different batches, ruling out bulk contamination. Furthermore, measurements were performed on both single crystals and microcrystalline powders to rule out surface contamination. For the single crystals, FIGs. 6A and 6D present the magnetic moment as a function of applied magnetic field parallel or perpendicular to the ab crystal plane, respectively. A strong predominantly paramagnetic response that decreases with temperature is observed. Surprisingly, the low-field region of the magnetic response (FIGs. 6B and 6E) features a ferromagnetic response at temperatures above about 50 K, revealed by an increasingly broadened hysteresis curve that persists even at 300 K (as reflected in the coercive field shown in FIGs. 6C and 6F). Corresponding results of powder measurements are shown in FIGs. 7A-D and FIGs. 8A-C. The magnetic results point toward a thermally activated exchange interaction, with an activation temperature in the range of from about 30 to about 50 K (about 2-5 meV). The magnetic behavior is similar to that observed in 2D magnets, except for the unusual thermally activated ferromagnetism.

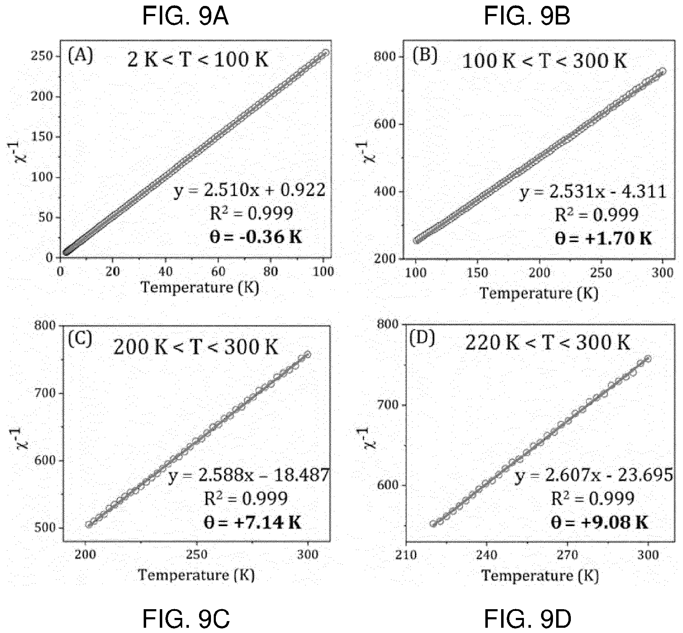

The behavior of the magnetization as a function of temperature, measured at a 1000 Oe magnetic field, is further analyzed using the Curie-Weiss equation, $\chi^{-1}=(T-\Theta)/X$, where $\chi$ is the magnetic susceptibility, T is the absolute temperature, and C and $\Theta$ are, respectively, the Curie-Weiss constant and temperatures (FIGs. 8A-C and 9A-D). Fitting the parameters of this equation against the measured $\chi^{-1}$ as a function of temperature (FIGs. 9A-D3) for the high-temperature regime (100-300 K), yields a positive $\Theta$, indicating ferromagnetic interactions. When the fit is performed at a lower temperature range, $\Theta$ is reduced, and at sufficiently low temperature, $\Theta$ becomes negative, indicating antiferromagnetic properties.

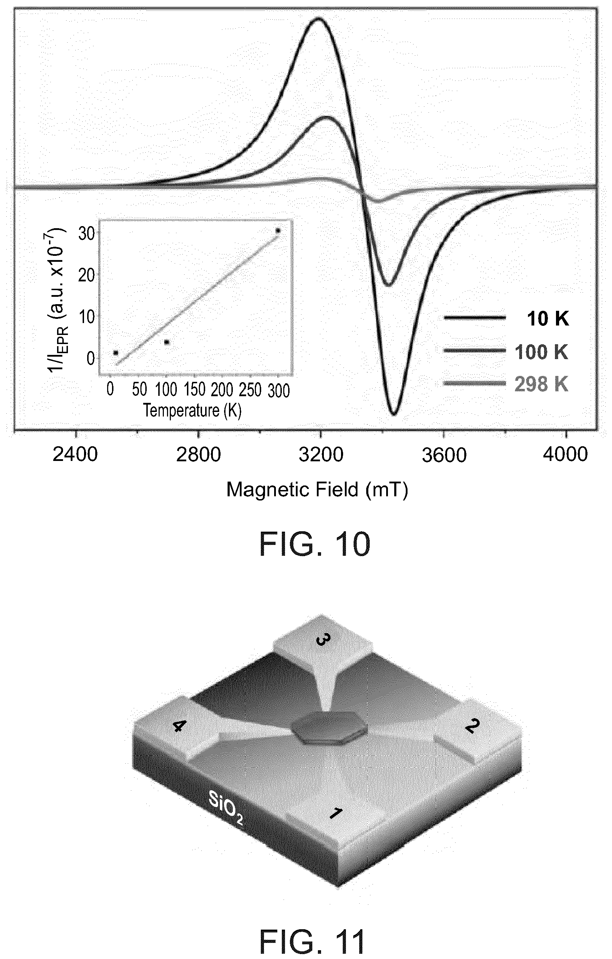

To further support the magnetic data, EPR spectra were measured for the L-Phe-Cu crystalline powder at both the Q- and X-bands (FIGs. 3A and 10, respectively). At 10 K, the EPR signal is strong, indicating mainly localized spin. With a temperature increase, the signal intensity decreases gradually, indicating an enhanced exchange interaction due to increased thermal motion and hence some delocalization of the unpaired electrons. The EPR results are therefore consistent with a temperature-activated exchange interaction between the Cu(II) ion and the lattice.

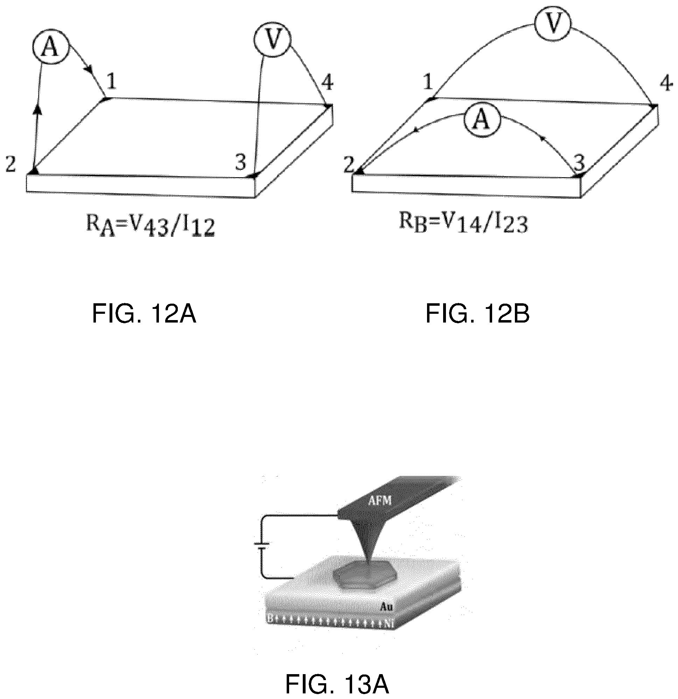

The magnetic measurements were augmented by temperature-dependent conduction measurements, performed using four gold contacts in a Van der Pauw geometry (FIGs. 11 and 12A-B). This configuration allows the measurement of conduction in the ab plane of the crystals. FIG. 3B shows the dependence of the surface resistance, $R_S$, on the temperature. A substantial increase in resistance was observed at low temperature, starting at about 50 K. This correlates well with the observed loss of ferromagnetism and is similar to the behavior observed at a metal-insulator transition.

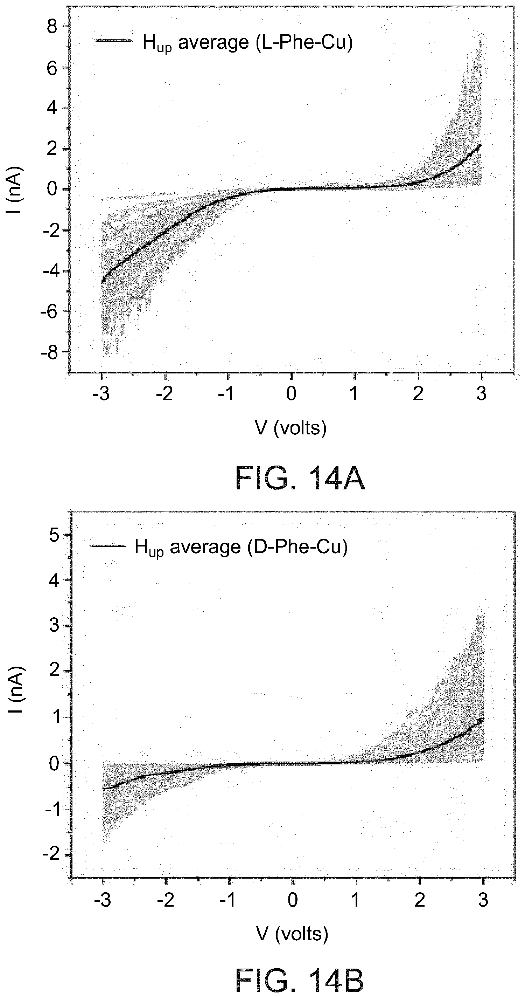

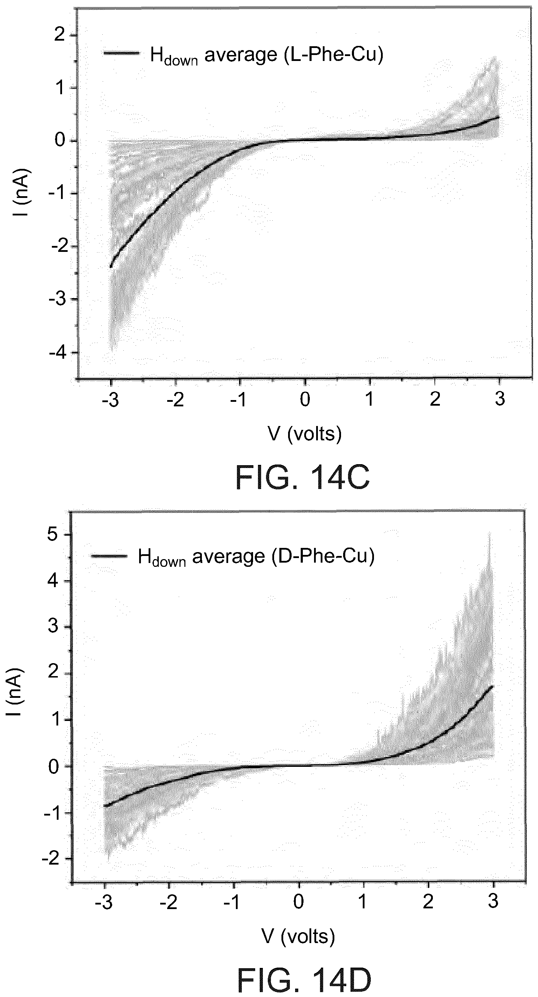

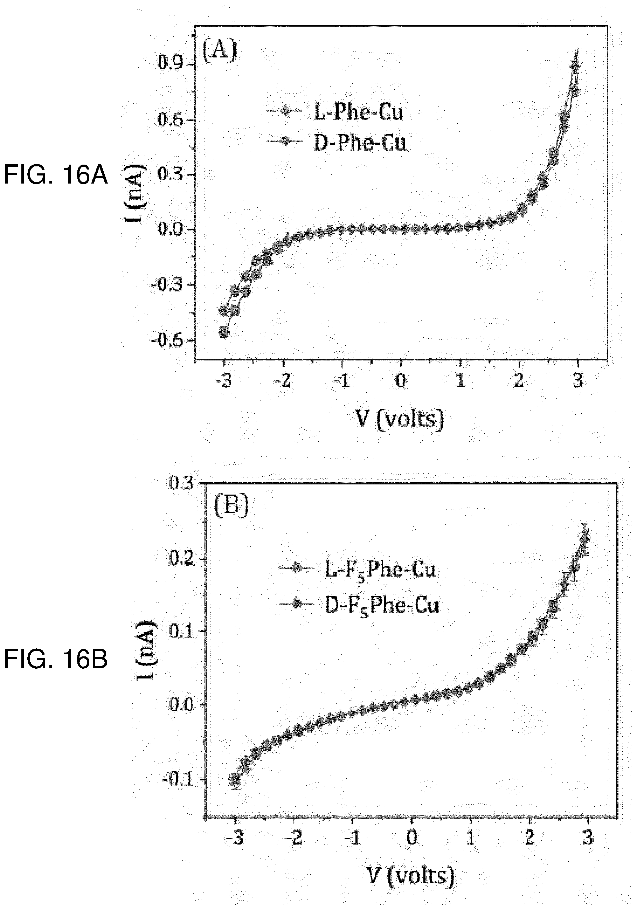

To explore spin-dependent conduction, room-temperature spin-dependent electron conduction studies were performed using a magnetic conductive probe atomic force microscope (mCP-AFM), based on a setup shown in FIG. 13A. The crystals were deposited on a gold-coated nickel (Ni 120 nm, Au 8 nm) substrate. The substrate magnetization direction (up or down) was controlled by an external magnetic field, oriented perpendicular to the Ni plane (for details, see the Methods section). The AFM was fitted with a nonmagnetic Pt tip. Prior to the conduction studies, the morphology of the samples was analyzed using AFM topography images (FIGs. 2D and 2H), and it was established that the conduction measurements are performed along the short (about 300 nm) c-axis of the crystals. Measurements were taken at different sites of each crystal and for several crystals of each type, and are shown in FIGs. 14A-16B.

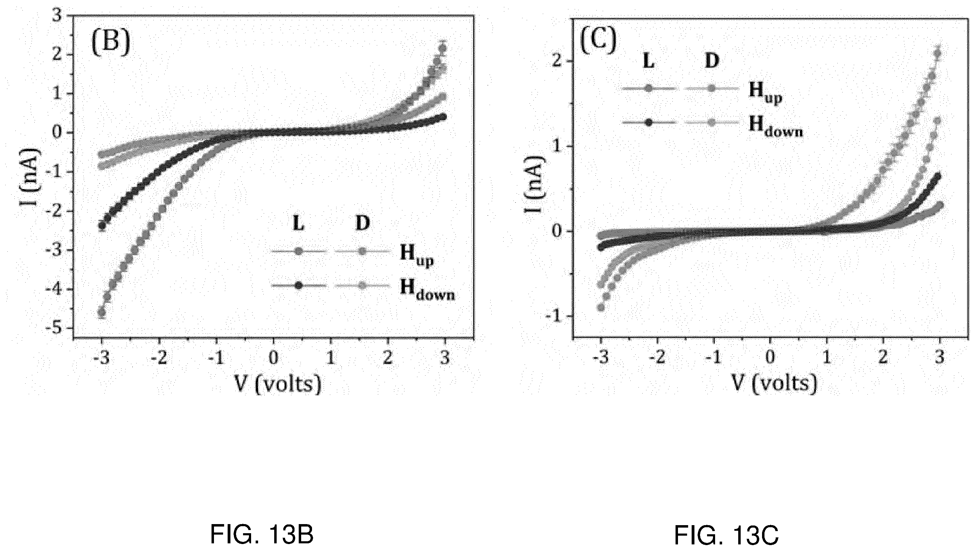

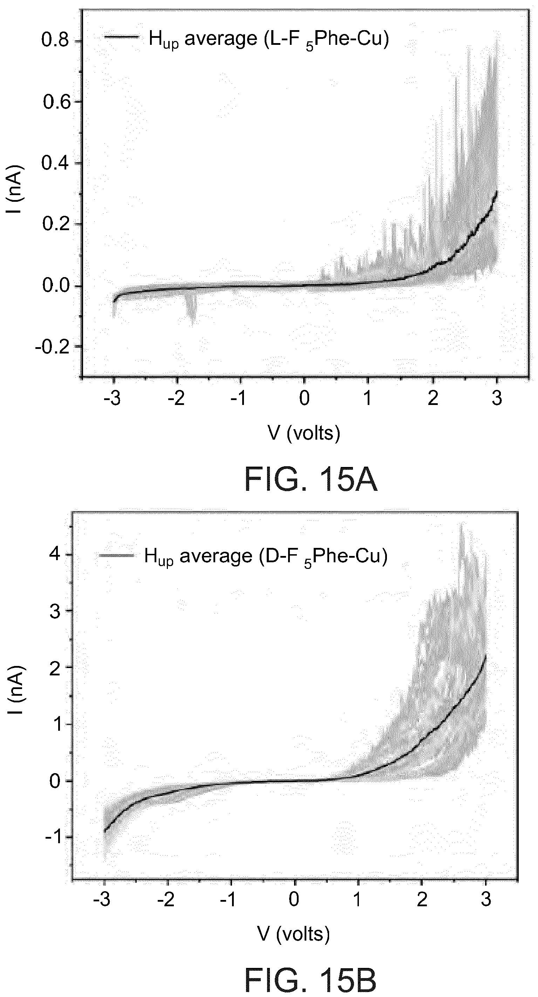

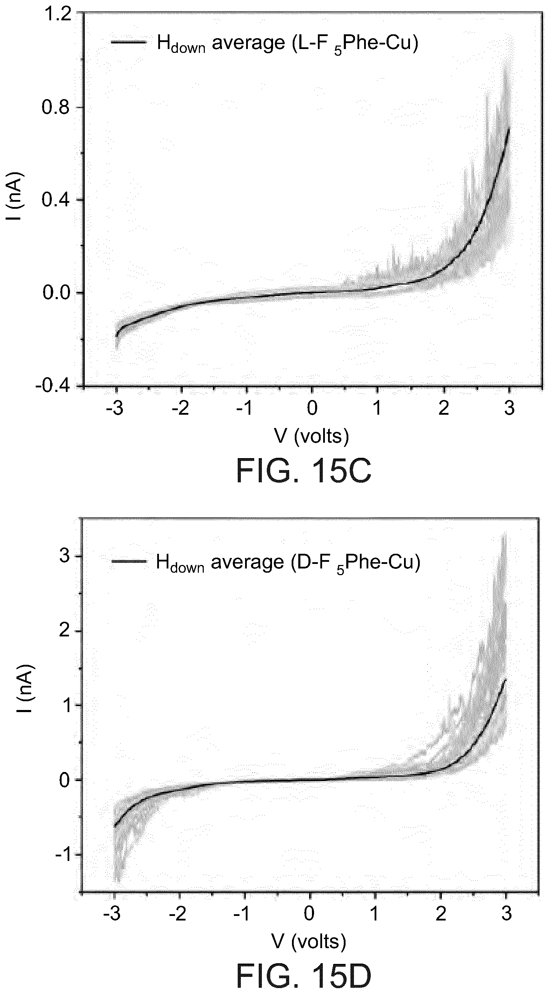

FIGs. 13B and 13C show the obtained current-voltage (I-V) curves for D- and L-Phe-Cu crystals (FIG. 13B) and D- and L-$F_5$Phe-Cu crystals (FIG. 13C). Each curve is an average over 50 to 100 individual measurements (see FIGs. 14A-D and 15A-D). The I-V measurements indicate that the 300 nm thick crystals behave as a large-gap semiconductor. Spin-dependent conduction is observed, even though the electrons are transported through a much longer medium than in former studies on chiral systems. For D-Phe-Cu (L-Phe-Cu), the current is higher when electrons are injected from the down-magnetized (up-magnetized) substrate. The opposite is true for the $F_5$Phe-Cu crystal. Quantitatively, at +3 V, the degree of spin polarization, defined as $(I_U - I_D)/(I_U + I_D)$, where $I_U$ and $I_D$ are the currents measured with the Ni magnetized up and down, respectively, is about 27% (about 68%) for the D-Phe-Cu (L-Phe-Cu) enantiomer. Correspondingly, the spin polarization measured for the $F_5$Phe-Cu crystal was found to be about 24% (about 39%) for the D(L) enantiomer. Although ferroelectric behavior at room temperature could not be ascertained directly, the asymmetry observed in the I-V curves may be explained by a net polarization in the crystals.

Based on the CISS effect alone, the current magnitude for the L-enantiomer with the up-magnetized substrate should be the same as that for the D-enantiomer with the down-magnetized substrate. FIGs. 13A and 13B show that this is not the case. Instead, for Phe-Cu ($F_5$Phe-Cu), the current measured with the L-enantiomer is generally higher (lower) than that for the D-enantiomer. This can be rationalized by the observed room-temperature ferromagnetism. Whereas the preferred spin injection depends on the handedness (L or D), the preferred spin transport also depends on the magnetization direction of the molecular ferromagnet, independent of chirality. Therefore, a large current is observed only if both effects support the same spin preference. Given that all measured crystals were magnetized with a magnetic field pointing up (see detailed discussion in the Methods section), this is indeed the case for L-Phe-Cu (FIG. 13B): when the injected spin is up (i.e., spin aligned antiparallel to the electron velocity), both conditions for spin transfer are favorable and conduction is high; when the opposite spin is injected, it is not preferred by chirality or magnetization, and the current is low. For the D-enantiomer, chirality does not prefer the injection of spin-up electrons. However, the magnetism allows their conduction through the crystals. Hence, only one condition for conduction is fulfilled. For injection of spin-down, the chirality condition is favorable for the spin but the magnetic condition is not. Thus, in the case of the D-enantiomer, there are never two optimal conditions for spin transport and therefore the current is intermediate.

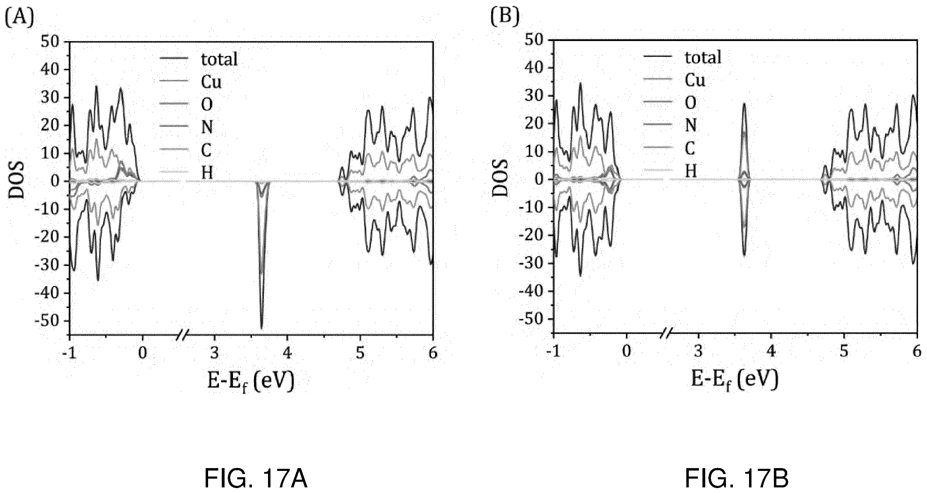

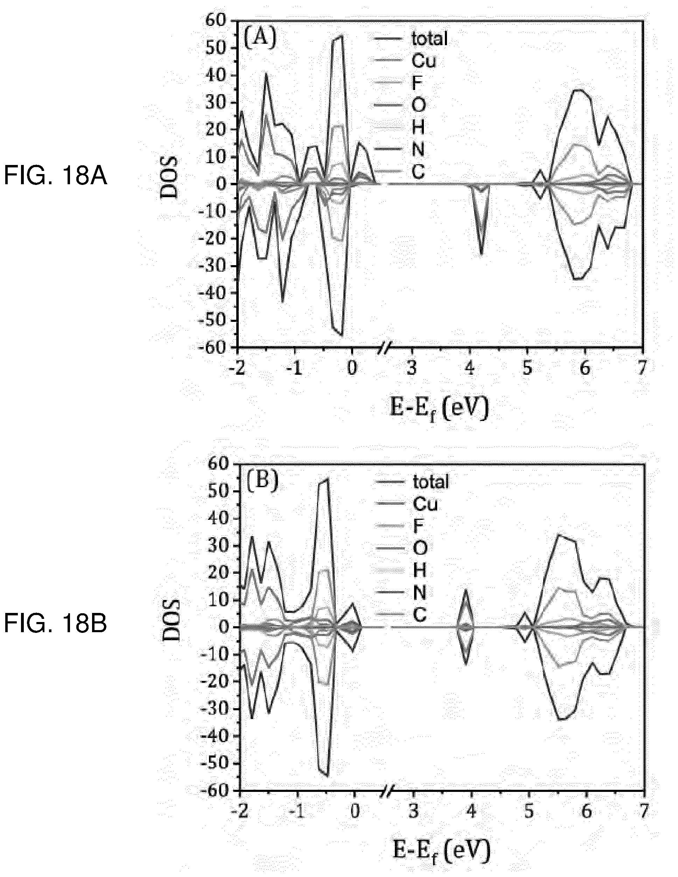

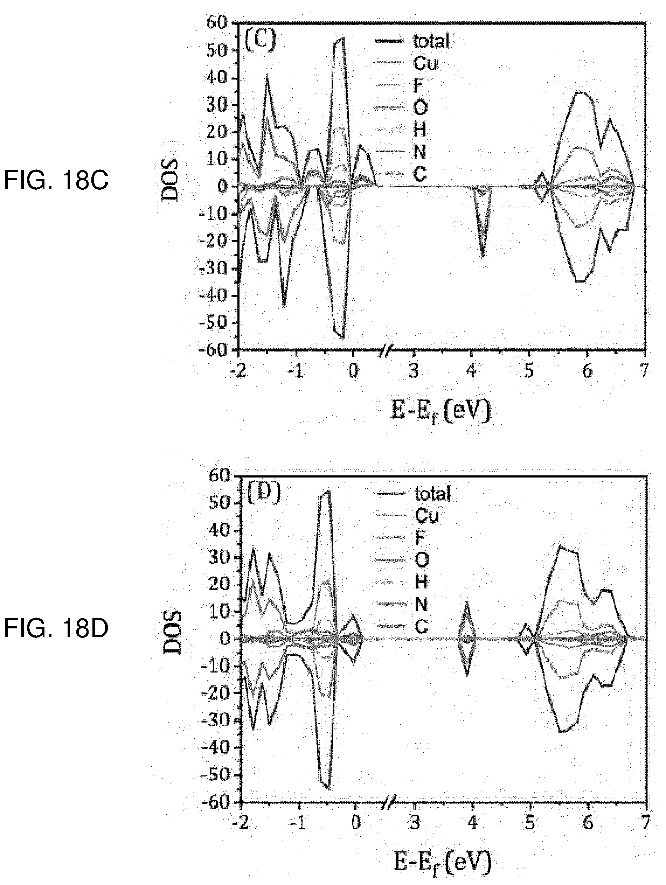

To gain insight into the unconventional electronic and magnetic properties of the crystals, DFT calculations were performed. Computational details are given in the Methods section. Computational results for the L-enantiomer are shown in FIGs. 17A-B. Results for the fluorinated crystals are very similar and are shown in FIGs. 18A-D.

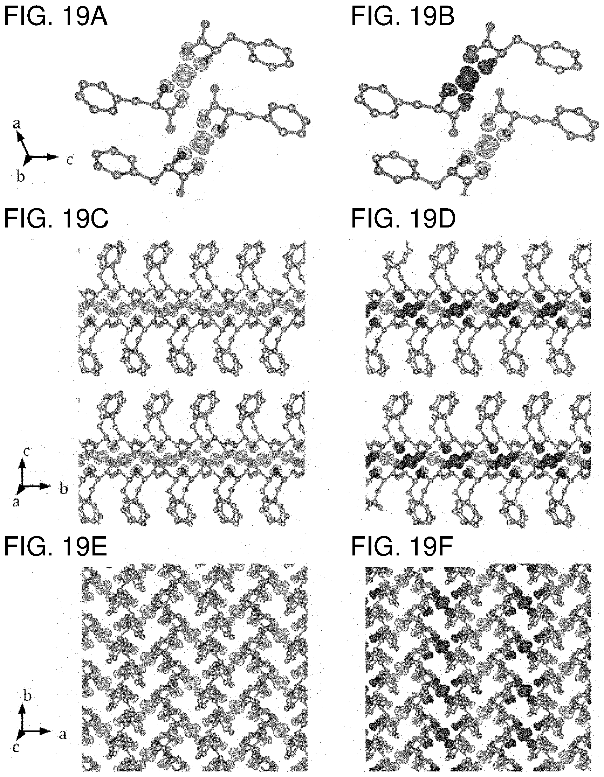

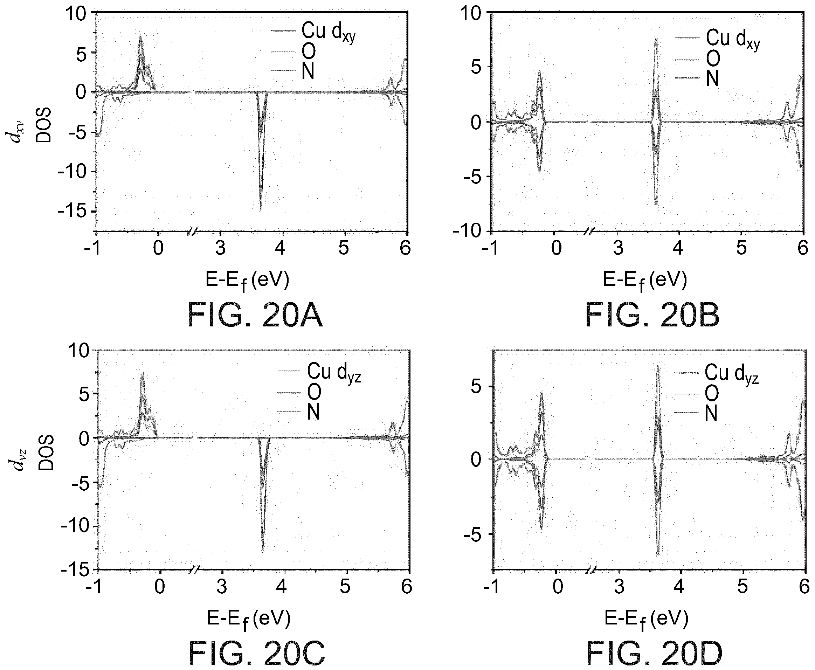

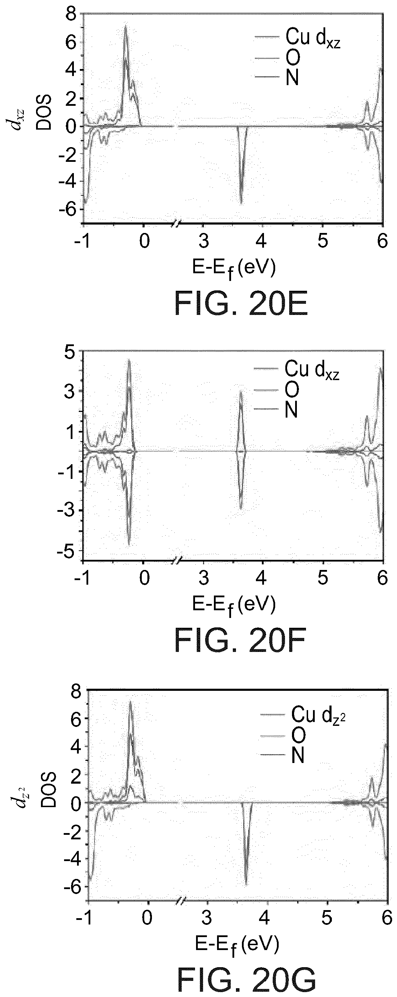

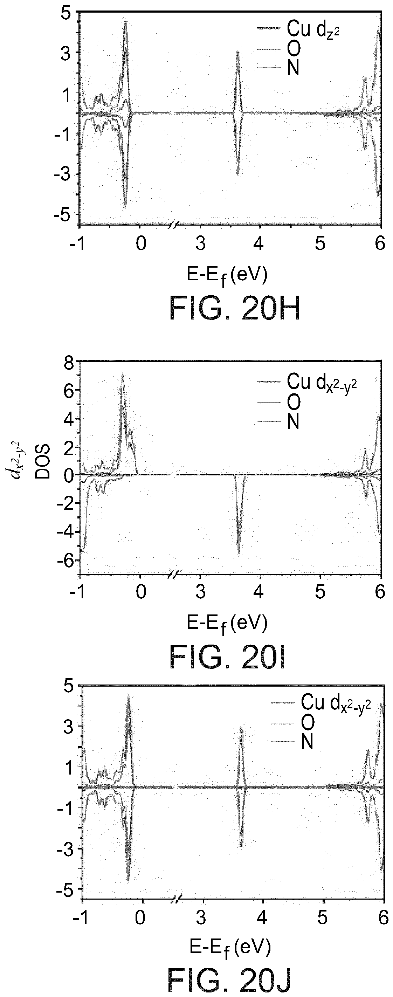

Both ferromagnetic and an antiferromagnetic state were stabilized in the DFT calculations, with the energy of the antiferromagnetic state being lower by about 3.5 meV per unit cell. The density of states for the ferromagnetic and antiferromagnetic phases of L-Phe-Cu is given in FIGs. 17A-B, and the associated spin density distribution is given in FIGs. 19A-F. The data show that the spin density is mainly centered on the copper atom and adjacent ligand moieties. Orbital-resolved densities of states, are shown in FIGs. 20A-J. The entire Cu + ligand entity can then be thought of as one spin-polarized unit, which couples in-plane, ferromagnetically or antiferromagnetically, to nearby Cu + ligand units, resembling 2D magnetic phenomena. Hence, the $Cu^{2+}$ ions are coupled indirectly, even at the geometry corresponding to the low-temperature structure, with the molecular moieties surrounding each $Cu^{2+}$ ion playing a role in facilitating the magnetism.

Interpreting the energy difference between the ferromagnetic and an antiferromagnetic states as the thermodynamic energy needed to flip the spin density at and around one $Cu^{2+}$ ion in the unit cell, these results suggest that no ferromagnetic response is expected below about 40 K, which, given the approximations inherent in the calculations, is in good qualitative agreement with experiment. At higher temperatures, one can expect some filling of the ferromagnetic state and therefore coexistence of ferromagnetic and antiferromagnetic states, explaining the onset of ferromagnetic hysteresis and its above-discussed impact on transport. The spin density suggests that for a given spin-polarized electron these states facilitate transport from one $Cu^{2+}$ ion to its adjacent neighbor for the ferromagnetic state but not for the antiferromagnetic state, where the same spin polarization occurs only on the second-nearest neighboring $Cu^{2+}$ ion. This explains why the conductivity drops for temperatures low enough such that the antiferromagnetic state dominates (see FIGs. 3A-B).

It is noted that dynamic phenomena may also explain temperature-activated ferromagnetism. Magnetic order may form owing to the interaction of the spin on the copper ion with lattice dynamics in the crystals, or by a magnetic field created locally by acoustic chiral phonons, which is manifested as an enhanced long-range exchange interaction. A possible role of chirality in obtaining temperature-activated ferromagnetism is that when the $Cu^{2+}$ ion vibrates against the chiral lattice, it causes charge polarization. Because of the chirality, the charge polarization is accompanied by spin polarization, which in turn induces spin polarization on the next Cu ion. Such a dynamic effect would be consistent with the EPR results presented above.

This Example showed that bioinspired chiral metal-organic crystals support room-temperature, long-range, chirality-induced spin-selective electron conduction. These crystals are found to be weakly ferromagnetic and ferroelectric. The observed ferromagnetism is thermally activated, so that the crystals are antiferromagnetic at low temperatures and become ferromagnetic above about 50 K. Without wishing to be bound to any particular theory, this unexpected behavior can be explained in terms of indirect interaction between the unpaired electrons on the Cu ions, mediated via the chiral lattice, which results in a low-lying thermally populated ferromagnetic state.

### Example 2

### Exemplified Spin Memory-Resistor

This Example describes the use of chiral metal-organic crystals with non-conventional magnetic properties, for the fabrication of an organic chiral spin nonlinear spin memory-resistor (memristor), based on the CISS effect. The device described in this Example consists of an irregular memristor loop, which depends on both the charges and spin trapping. This Example demonstrates that a simple device can exhibit multilevel controlled states, generated by the magnetization of the source. In this Example, changing the source magnetization slows a six-level readout for two terminal organic devices.

The main application found for organic materials in electronic applications is the organic light-emitting diodes (OLED). For memory applications, organic materials suffer from having relatively low conductivity and large variability. In spintronics, although organic materials having a notable relatively long spin lifetime, the low conduction and the need to interface organic materials with inorganic ferromagnetic electrodes make the use of organic materials a challenge.

This Example presents chiral metal-organic crystals (MOCs), as organic materials that have relatively good conduction and in addition, interesting magnetic properties, and demonstrates the use of these crystals as spin memory-resistors (memristors) that act differently from the known oxide-based inorganic memristors. These MOCs can have more than 2 bits of memory and the fabricated devices are chemically and structurally stable.

A memristor is a nonlinear component with properties that cannot be replicated with any combination of the other fundamental components, combines a persistent memory with electrical resistance. In other words, a memristor has a non-linear resistance that can act as a universal memory that enables logic operations. The device presented in this Example combines a memristor's behavior with multilevel logic.

The CISS effect offers a unique approach for meeting the challenge of simple and small memristor fabrication. Because of the CISS effect, chiral molecules and crystals can act as efficient spin filters. The MOC described in this example consists of Cu-phenylalanine crystals that are chiral. Example 1 above showed that these crystals were shown to have good conduction and ferromagnetic properties at room temperature.

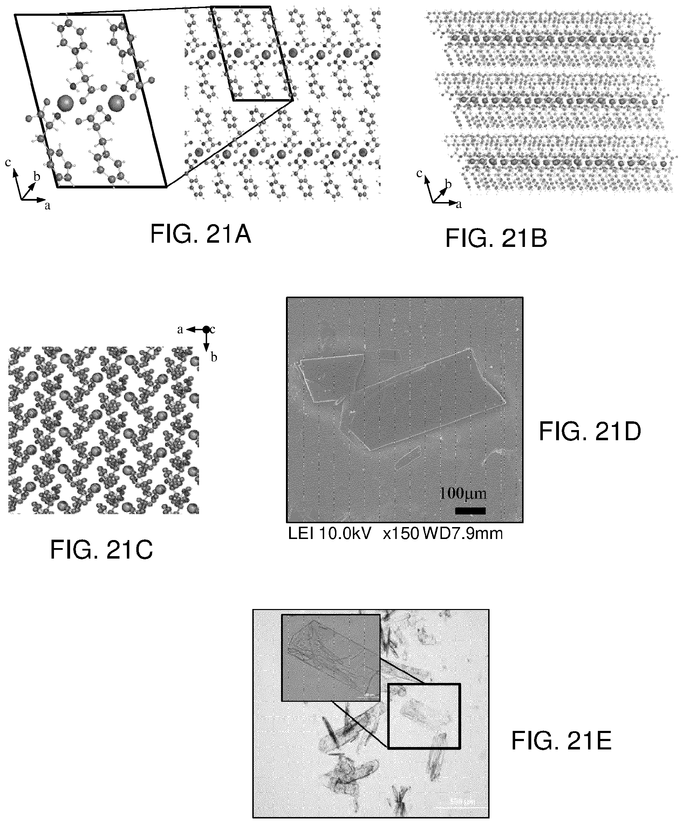

D-enantiomers of the amino acid phenylalanine were crystallized with copper ions and characterized by X-ray analysis and circular dichroism (CD) spectroscopy. The asymmetric units of the crystal consist of phenylalanine dimer coordinating a copper atom, and the unit-cell consists of two dimers, as shown in FIG. 21A. FIGs. 21B and 21C show present a high-order assemblies of the crystal viewed along different axes, and FIGs. 21D and 21E show scanning electron microscope (SEM) and optical microscope images, respectively.

FIGs. 22A and 22B show the absorption and the CD spectra of the crystal, respectively. FIG. 22C shows the absorption spectra when the crystal is excited with clockwise (RCL) and counter-clockwise (LCL) circular polarized light.

All the electrical measurements were performed in a planar architecture when the device is located on a thermal oxide ($SiO_2$-100 nm) p-type silicon wafer. The optical microscope image and the graphic sketch of the right-handed D-enantiomers of phenylalanine MOC crystals located between two gold pads are shown in the inset in FIG. 22D. This figure also presents the photocurrent through the crystals measured at a bias of 5V, for left or right circular polarized light (532 nm). As shown, the photocurrent is stronger by about 10% for the right circular polarization, despite that the light absorption at this wavelength is similar for the two circular polarizations (see FIG. 22C). Therefore, the large dependence of the photocurrent on the light circular polarization results from the preferred spin conductivity.

Example 1 showed that conduction through the crystals is spin selective, due to the CISS effect. Since the excitation by circular polarized light results in exciting one spin direction, following the excitation, there is an electron in the excited state with one specific spin and the hole in the ground state has the same specific spin. In accordance with the two-band conduction model, the hole conduction is expected to be improved as a result of the scattering reduction for the same spin. When this spin is the spin preferred for conduction through the chiral system, a large photocurrent is produced. A similar improvement in conductivity after magnetizing the Cu atoms is presented shown in FIGs. 23A-F. For the opposite circular polarization excitation, the preferred conducted spin faces a spin blockade on the excited Cu ions and its conduction will be suppressed. The Inventors also measured magneto resistance hysteresis at room temperature.

FIG. 22E shows the temperature-dependent resistance, which indicates that at a low temperature, when the crystal becomes antiferromagnetic, the resistance increases, whereas at a higher temperature, of above about 100K, the resistance follows the Arrhenius behavior, as shown in FIG. 22F. From this plot, the activation energy can be obtained. This activation energy corresponds to the band gap of the material and it was found to be about $24 \pm 2$ meV, and independent of the current flow. The Inventors found that the produced crystals were very stable under current and observed no deterioration when operating at 1 mA for many hours.

In this Example, three different types of devices have been used to study the spin memristor behaviour: a Hall device, a gated device, and a gated device with magnetic leads.

The first configuration studied is a Hall configuration. As shown in FIG. 23A, the Hall device contains six Au probes for measuring both the Hall and transport properties. The source-drain voltage was swiped from -15V to 15V and back at different rates. The Hall voltage was measured in parallel with the drain-source current, enabling one to correlate spin accumulation with current. The inset in FIG. 23B shows that memristive behaviour exists when the drain-source voltage is scanned. The nonlinear hysteresis loop of the spin memristor differs from the standard oxide-based memristor. In an oxide-based memristor, the current applied increases the resistance, since the current fills the charge trap states. The device of the present embodiments, in distinction, is based on magnetism induced by the current (similar to the light-induced magnetization explained above). Therefore, the resistance is reduced by applying the current.

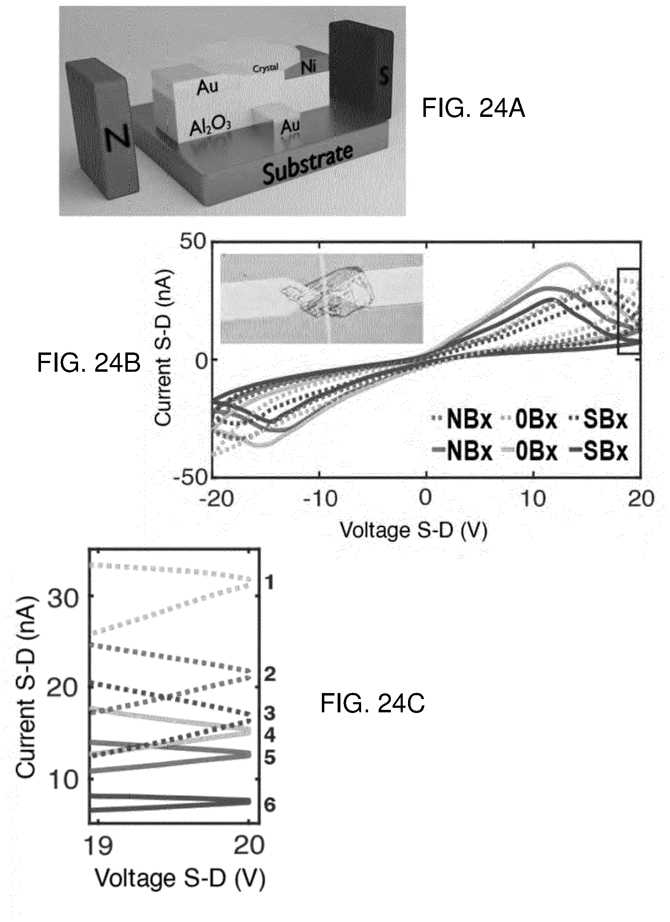

The device of the present embodiments exhibits a strong dependence of the hysteresis on the current sweep frequency and the hysteresis decays at a high frequency. This frequency dependence is presented in FIG. 24B. With a higher sweep rate, the distance between the two hysteresis peaks is reduced.

Note that different devices exhibit similar behaviour, for example, when comparing FIGs. 23B, 23C, and 23E. FIGs. 23C and 23D show the drain-source and the Hall voltage hysteresis, respectively, for another device that was used for obtaining the results shown in FIG. 23B. The Hall voltage response indicates that magnetization is generated when the current is driven. The Hall voltage is always negative, demonstrating that the spin polarization is due to the CISS effect, since the CISS effect generates the same magnetization when the current direction is switched. This is because the sign of the spin transported is reversed when the current direction is flipped. The large correlation between the Hall signal hysteresis and the drain-source hysteresis can be used in some embodiments of the present invention to reduce the device's noise.

Example 1 showed that the phenylalanine crystals exhibit ferromagnetic behaviour at room temperature, but the crystals become antiferromagnetic below 50K. Therefore, it is expected that a hysteresis that relates to the magnetic properties of the material disappears at low temperatures. The temperature dependence I vs. the V curves of a device is presented in FIG. 23E. As shown, the hysteresis gradually becomes smaller with decreasing temperature and is almost negligible at 50K. Below 50K, however, the resistance becomes so high that the current observed is extremely low. This is also consistent with the observations shown in Example 1.

Direct magnetization measurements, as a function of temperature, are presented in FIG. 23F, along with a scheme of the device (inset). In these measurements, the residue signals from the substrate and the metal electrode were subtracted by deducting the signal obtained for source-drain voltages at 0.5V and 0V. When the voltage was kept constant, the temperature was reduced from 300K to 3K and then restored. With decreasing temperature, the difference in magnetization between the temperatures scanned up and down gets smaller. Note that upon reducing the temperature, the resistance of the device increases, especially at temperatures below 50K. Therefore, the current decreases. The observed temperature-dependent hysteresis is consistent with current-induced magnetization. Below 50K, the system becomes, partially at least, antiferromagnetic and therefore magnetization is reduced. At temperatures above 50K, the increase in magnetization upon cooling is consistent with ferromagnetism. Upon warming, the magnetic moment reduces, but the reduction is partially compensated by an increase in the current, resulting in the increased magnetization.

The current-induced magnetization effect was used to generate a multi-level spin memristor, as shown in FIGs. 24A-C. The set-up is shown in FIGs. 24A and 24B. The bottom gate was used to tune the density of the carriers in the system. The source was a magnetic Ni pad and the drain was an Au pad. A magnetic field of about 0.25 Tesla was applied using a permanent magnet in the direction of the current. The memristor behaviour was controlled by two in-plane magnetization directions: North and South and by random magnetization. In this way, it was possible to inject polarized spins into the crystal and to apply electric potential using the gate. Current versus voltage measurements were performed under a magnetic field and with different gate voltages.

The multi-level logic is shown in FIG. 24C. The parameters of the levels can be tuned by choosing a different drain-source voltage or gate voltage. Note that the direction of the external magnetic field applied does not coincide perfectly with the direction of the current-induced magnetization in the crystal. Consequently, the hysteresis observed is the largest if no external magnetic field is applied and the magnetic moment is only due to the current-induced magnetization, with no interference of the external magnetic field.

The observed memristor behaviour results from the special properties of the crystal, which combine chirality and ferromagnetism at room temperature. The current through the chiral crystal is spin selective, due to the CISS effect. The spin current induces the magnetization of the unpaired electrons on the $Cu^{+2}$ ions. Hence, the hysteresis in resistance and non-linearity results from reducing scattering within the crystal, upon the formation of ferromagnetic domains. The copper ions are responsible for the relatively good conduction of the crystals at room temperature. As was observed by calculations, the ions states lie just above the highest lying molecular orbitals (HOMO) and they indicate a barrier of about 20 meV for conduction. In addition, as shown in FIGs. 22A-F, when the crystals are illuminated, the current is influenced by the circular polarization of the light. As a result of all these properties, the conduction through the crystals is susceptible to both electric and magnetic fields, as well as to the spin direction of electrons injected from the magnetic source. This provides a wide range of control parameters for a two-terminal device (FIGs. 23A-F). These control parameters allow achieving multilevel memrestive logic using simple organic materials (FIGs. 24A-C).

This Example showed that by using organic materials can be used for fabricating devices with new properties that are stable for a long time at ambient conditions. The ability to combine chirality and magnetism with good conduction makes the crystal of the present embodiments useful for many spintronic applications, particularly devices having a size on the order of tens of nanometers.

REFERENCES

Miller, J. S. Organic- and Molecule-Based Magnets. Mat. Today 2014, 17, 224-235.

Bogani, L.; Wernsdorfer, W. Molecular Spintronics Using Single-Molecule Magnets. Nat. Mat. 2008, 7, 179-186.

Sessoli, R. Magnetic Molecules Back in the Race. Nature 2017, 548, 400-401.

Alexandropoulos, D. I.; Vignesh, K. R.; Stamatatos, T. C.; Dunbar, K. R. Rare "Janus"-Faced {FeII7} Single-Molecule Magnet Exhibiting Intramolecular Ferromagnetic Interactions. Chem. Sci. 2019, 10, 1626-1633.

Oshio, H.; Hoshino, N.; Ito, T. Superparamagnetic Behavior in an Alkoxo-Bridged Iron(II) Cube. J. Am. Chem. Soc. 2000, 122, 12602-12603.

Goodwin, C. A. P.; Ortu, F.; Reta, D.; Chilton, N. F.; Mills, D. P. Molecular Magnetic Hysteresis at 60 Kelvin in Dysprosocenium. Nature 2017, 548, 439-442.

Coronado, E.; Gómez-García, C. J.; Nuez, A.; Romero, F. M.; Waerenborgh, J. C. Synthesis, Chirality, and Magnetic Properties of Bimetallic Cyanide-Bridged Two-Dimensional Ferromagnets. Chem. Mater. 2006, 18, 2670-2681.

Shiomi, D.; Kanzaki, Y.; Okada, S.; Arima, R.; Miyazaki, Y.; Inaba, A.; Tanaka, R.; Sato, K.; Taku, T. An Enantiopair of Organic Ferromagnet Crystals Based on Helical Molecular Packing of Achiral Organic Radicals. J. Phys. Chem. Lett. 2011, 2, 3036-3039.

Dhara, B.; Tarafder, K.; Jha, P. K.; Panja, S. N.; Nair, S.; Oppeneer, P. M.; Ballav, N. Possible Room-Temperature Ferromagnetism in Self-Assembled Ensembles of Paramagnetic and Diamagnetic Molecular Semiconductors. J. Phys. Chem. Lett. 2016, 24, 4988-4995.

Dhara, B.; Jha, P. K.; Gupta, K.; Bind, V. K.; Ballav, N. Diamagnetic Molecules Exhibiting Room-Temperature Ferromagnetism in Supramolecular Aggregates. J. Phys. Chem. C 2017, 121, 12159-12167.

Yang, B.; Xiao, Z.; Yuan, Y.; Jayaraman, T. V.; Shield, J. E.; Skomski, R.; Huang, J. Room-Temperature Organic Ferromagnetism in the Crystalline Poly(3-hexylthiophene): Phenyl-C61-Butyric Acid Methyl Ester Blend Film. Polymer 2013, 54, 490-494.

Miller, J. S.; Epstein, A. J.; Reiff, W. M. Molecular/Organic Ferromagnets. Science 1988, 240, 40-47.

Kinoshita, M. Ferromagnetism of Organic Radical Crystals. Jpn. J. Appl. Phys. 1994, 33, 5718-5733.

Phan, H.; Herng, T. S.; Wang, D.; Li, X.; Zeng, W.; Ding, J.; Loh, K. P.; Wee, A. T. S.; Wu, J. Room-Temperature Magnets Based on 1,3,5-Triazine-Linked Porous Organic Radical Frameworks. Chem 2019, 5, 1223-1234.

Naaman, R.; Paltiel, Y.; Waldeck, D. H. Chiral Molecules and the Electron Spin. Nat. Rev. Chem. 2019, 3, 250-260.

Göhler, B.; Hamelbeck, V.; Markus, T. Z.; Kettner, M.; Hanne, G. F.; Vager, Z.; Naaman, R.; Zacharias, H. Spin Selectivity in Electron Transmission Through Self-Assembled Monolayers of Double-Stranded DNA. Science 2011, 331, 894-897.

Xie, Z.; Markus, T. Z.; Cohen, S. R.; Vager, Z.; Gutierrez, R.; Naaman, R. Spin Specific Electron Conduction through DNA Oligomers. Nano Lett. 2011, 11, 4652-4655.

Mishra, D.; Markus, T. Z.; Naaman, R.; Kettner, M.; Göhler, B.; Zacharias, H.; Friedman, N.; Sheves, M.; Fontanesi, C. Spin-Dependent Electron Transmission Through Bacteriorhodopsin Embedded in Purple Membrane. Proc. Natl. Acad. Sci. U. S. A. 2013, 110, 14872-14876.

Eckshtain-Levi, M.; Capua, E.; Refaely-Abramson, S.; Sarkar, S.; Gavrilov, Y.; Mathew, S. P.; Paltiel, Y.; Levy, Y.; Kronik, L.; Naaman, R. Cold Denaturation Induces Inversion of Dipole and Spin Transfer in Chiral Peptide Monolayers. Nat. Commun. 2016, 7, 10744.

Zwang, T. J.; Hürlimann, S.; Hill, M. G.; Barton, J. K. Helix-Dependent Spin Filtering through the DNA Duplex. J. Am. Chem. Soc. 2016, 138, 15551-15554.

Abendroth, J. M.; Cheung, K. M.; Stemer, D. M.; El Hadri, M. S.; Zhao, C.; Fullerton, E. E.; Weiss, P. S. Spin-Dependent Ionization of Chiral Molecular Films. J. Am. Chem. Soc. 2019, 141, 3863-3874.

Aragonès, A. C.; Medina, E.; Ferrer-Huerta, M.; Gimeno, N.; Teixidó, M.; Palma, J. L.; Tao, N.; Ugalde, J. M.; Giralt, E.; Díez-Pérez, I.; Mujica, V. Measuring the Spin-Polarization Power of a Single Chiral Molecule. Small 2017, 13, 1602519.

Mishra, S.; Pirbadian, S.; Mondal, A. K.; El-Naggar, M. Y.; Naaman, R. Spin-Dependent Electron Transport through Bacterial Cell Surface Multiheme Electron Conduits. J. Am. Chem. Soc. 2019, 141, 19198-19202.

Lu, H.; Wang, J.; Xiao, C.; Pan, X.; Chen, X.; Brunecky, R.; Berry, J. J.; Zhu, K.; Beard, M. C.; Vardeny, Z. V. Spin-Dependent Charge Transport through 2D Chiral Hybrid Lead-Iodide Perovskites. Sci. Adv. 2019, 5, eaay0571.

Nguyen, V.; Zhu, R.; Jenkins, K.; Yang, R. Self-Assembly of Diphenylalanine Peptide with Controlled Polarization for Power Generation. Nat. Comm. 2016, 7, 13566.

Yuan, H.; Han, P.; Tao, K.; Liu, S.; Gazit, E.; Yang, R. Piezoelectric Peptide and Metabolite Materials. Research 2019, 9025939.

Spaldin, N. A.; Ramesh, R. Advances in Magnetoelectric Multiferroics. Nat. Mat. 2019, 18, 203-212.

Shabbir, B.; Nadeem, M.; Dai, Z.; Fuhrer, M.; Xue, Q-K.; Wang, X.; Bao, Q. Long Range Intrinsic Ferromagnetism in Two Dimensional Materials and Dissipationless Future Technologies. Appl. Phys. Rev. 2018, 5, 041105.

Kravchenko, S. V.; Kravchenko, G. V.; Furneaux, J. E.; Pudalov, V. M.; D'Iorio, M. Possible Metal Insulator Transition at B = 0 in Two Dimensions. Phys. Rev. B 1994, 50, 8039-8042.

Hanein, Y.; Nenadovic, N.; Shahar, D.; Shtrikman, H.; Yoon, J.; Li, C. C.; Tsui, D. C. Linking Insulator-to-Metal Transitions at Zero and Finite Magnetic Fields. Nature 1999, 400, 735-737.

Rastogi, A.; Brahlek, M.; Ok, J. M.; Liao, Z.; Sohn, C.; Feldman, S.; Lee, H. N. Metal-Insulator Transition in (111) SrRuO3 Ultrathin Films. APL Mater. 2019, 7, 091106.

Kiran, V.; Cohen, S. R.; Naaman, R. Structure Dependent Spin Selectivity in Electron Transport Through Oligopeptides. J. Chem. Phys. 2017, 146, 092302.

Michaeli, K.; Varade, V.; Naaman, R.; Waldeck, D. H. A New Approach Towards Spintronics - Spintronics with no Magnets. J. Phys. Condens. Matter. 2017, 29, 103002.

Kresse, G.; Furthmüller, J. Efficient Iterative Schemes for ab Initio Total-Energy Calculations Using a Plane-Wave Basis Set. Phys. Rev. B 1996, 54, 11169-11186.

Perdew, J. P.; Burke, K.; Ernzerhof, M. Generalized Gradient Approximation Made Simple. Phys. Rev. Lett. 1996, 77, 3865-3868.

Perdew, J. P.; Burke, K.; Ernzerhof, M. Generalized Gradient Approximation Made Simple. Phys. Rev. Lett. 1997, 78, 1396-1396.

Tkatchenko, A.; Scheffler, M. Accurate Molecular Van der Waals Interactions from Ground-State Electron Density and Free-Atom Reference Data. Phys. Rev. Lett. 2009, 102, 073005.

Kronik, L.; Tkatchenko, A. Understanding Molecular Crystals with Dispersion-Inclusive Density Functional Theory: Pairwise Corrections and Beyond. Acc. Chem. Res. 2014, 47, 3208-3216.

Heyd, J.; Scuseria, G. E.; Ernzerhof, M. Hybrid Functionals Based on a Screened Coulomb Potential. J. Chem. Phys. 2003, 118, 8207-8215.

Heyd, J.; Scuseria, G. E.; Ernzerhof, M. Hybrid Functionals Based on a Screened Coulomb Potential. J. Chem. Phys. 2006, 124, 219906-219906.

Marom, N.; Hod, O.; Scuseria, G. E.; Kronik, L. Electronic Structure of Copper Phthalocyanine: A Comparative Density Functional Theory Study. J. Chem. Phys. 2008, 128, 164107.

Pratzer, M.; Elmers, H. J. Lateral Indirect Exchange Coupling in a Two-Dimensional Nanostripe Array. Phys. Rev. B 2002, 66, 033402.

Zhang, X.; Ali, N. Entropy Change at the Ferromagnetic-Antiferromagnetic Transition in the Intermetallic Compound Ce(Fe0.8Co0.2)2. J. Alloys Comp. 1994, 207/208, 300-303.

Flippen, R. B.; Darnell, F. J. Entropy Changes of Ferromagnetic-Antiferromagnetic Transitions from Magnetic Measurements. J. Appl. Phys. 1963, 34, 1094-1095.

Fransson, J.; Thonig, D.; Bessarab, P. F.; Bhattacharjee, S.; Hellsvik, J.; Nordström, L. Microscopic Theory for Coupled Atomistic Magnetization and Lattice Dynamics. Phys. Rev. Mat. 2017, 1, 074404.

Nomura, T.; Zhang, X.-X.; Zherlitsyn, S.; Wosnitza, J.; Tokura, Y.; Nagaosa, N.; Seki, S. Phonon Magnetochiral Effect. Phys. Rev. Lett. 2019, 122, 145901.

Korenev, V. L.; Salewski, M.; Akimov, I. A.; Sapega, V. F.; Langer, L.; Kalitukha, I. V.; Debus, J.; Dzhioev, R. I.; Yakovlev, D. R.; Müller, D.; Schröder, C.; Hövel, H.; Karczewski, G.; Wiater, M.; Wojtowicz, T.; Kusrayev, Yu. G.; Bayer, M. Long-Range p-d Exchange Interaction in a Ferromagnet-Semiconductor Hybrid Structure. Nat. Phys. 2016, 12, 85-91.

Kumar, A.; Capua, E.; Kesharwani, M. K.; Martin, J. M. L.; Sitbon, E.; Waldeck, D. H.; Naaman, R. Chirality-Induced Spin Polarization Places Symmetry Constraints on Biomolecular Interactions. PNAS 2017, 114, 2474-2478.

Macrae, C. F.; Edgington, P. R.; McCabe, P.; Pidcock, E.; Shields, G. P.; Taylor, R.; Towler, M.; van de Streek, J. Mercury: Visualization and Analysis of Crystal Structures. J. Appl. Cryst. 2006, 39, 453-457.

Damjanovic, D. Ferroelectric, Dielectric and Piezoelectric Properties of Ferroelectric Thin Films and Ceramics. Rep. Prog. Phys. 1998, 61, 1267-1324.

Bar-Chaim, N.; Brunstein, M.; Grunberg, J.; Seidman, A. Electric Field Dependence of the Dielectric Constant of PZT Ferroelectric Ceramics. J. Appl. Phys. 1974, 45, 2398-2405.

Wouters, D. J.; Willems, G.; Lee, E. G.; Maes, H. E. Elucidation of the Switching Processes in Tetragonal pzt by Hysteresis Loop and Impedance Analysis. Integrated Ferroelectrics 1997, 15, 79-87.

Monkhorst, H. J.; Pack, J. D. Special Points for Brillouin-Zone Integrations. Phys. Rev. B 1976, 13, 5188-5192.

Heyd, J.; Peralta, J. E.; Scuseria, G. E.; Martin, R. L. Energy Band Gaps and Lattice Parameters Evaluated with the Heyd-Scuseria-Ernzerhof Screened Hybrid Functional. J. Chem. Phys. 2005, 123, 174101.

Momma, K.; Izumi, F. VESTA 3 for Three-Dimensional Visualization of Crystal, Volumetric and Morphology Data. J. Appl. Cryst. 2011, 44, 1272-1276.

M. O'Neill, S. M. Kelly, Ordered Materials for Organic Electronics and Photonics. Advanced Materials. 23, 566-584 (2011).

S. R. Forrest, M. E. Thompson, Introduction: Organic Electronics and Optoelectronics. Chem. Rev. 107, 923-925 (2007).

T. Aida, E. W. Meijer, S. I. Stupp, Functional Supramolecular Polymers. Science. 335, 813-817 (2012).

U. Mitschke, P. Bäuerle, The Electroluminescence of Organic Materials. Journal of Materials Chemistry 10, 1471-1507 (2000).

J.-S. Park, H. Chae, H. K. Chung, S. I. Lee, Thin Film Encapsulation for Flexible AM-OLED: A Review. Semiconductor Science and Technology 26, 034001 (2011).

J. H. Burroughes, D. D. C. Bradley, A. R. Brown, R. N. Marks, K. Mackay, R. H. Friend, P. L. Burns, A. B. Holmes, Light-Emitting Diodes based on Conjugated Polymers. Nature. 347, 539-541 (1990).

I. Valov, M. Kozicki, Organic Memristors Come of Age. Nature Materials. 16, 1170-1172 (2017).

H. Wang, F. Meng, B. Zhu, W. R. Leow, Y. Liu, X. Chen, Resistive Switching Memory Devices Based on Proteins. Advanced Materials. 27, 7670-7676 (2015).

W. J. M. Naber, S. Faez, W. G. van der Wiel, Organic Spintronics. arXiv:cond-mat/0703455 (2007) (available at www(dot)arxiv(dot)org/abs/cond-mat/0703455).

D. Sun, E. Ehrenfreund, Z. V. Vardeny, The First Decade of Organic Spintronics Research. Chemical Communications 50, 1781-1793 (2014).

Y. Huai, Spin-Transfer Torque MRAM (STT-MRAM): Challenges and Prospects. AAPPS Bulletin 18, 33-40 (2008).

J. A. Katine, E. E. Fullerton, Device Implications of Spin-Transfer Torques. Journal of Magnetism and Magnetic Materials. 320, 1217-1226 (2008).

S. Bhatti, R. Sbiaa, A. Hirohata, H. Ohno, S. Fukami, S. N. Piramanayagam, Spintronics based random access memory: a review. Materials Today. 20, 530-548 (2017).

A. Prakash, H. Hwang, Multilevel Cell Storage and Resistance Variability in Resistive Random Access Memory. Physical Sciences Reviews. 1, 6 (2016).

I. Vourkas, G. C. Sirakoulis, Emerging Memristor-Based Logic Circuit Design Approaches: A Review. IEEE Circuits and Systems Magazine. 16, 15-30 (2016).

L. Chua, Memristor-The missing circuit element. IEEE Transactions on Circuit Theory. 18, 507-519 (1971).

Y. Halawani, B. Mohammad, D. Homouz, M. Al-Qutayri, H. Saleh, Modeling and Optimization of Memristor and STT-RAM-Based Memory for Low-Power Applications. IEEE Transactions on Very Large Scale Integration (VLSI) Systems. 24, 1003-1014 (2016).

H. Al-Bustami, G. Koplovitz, D. Prime, S. Yochelis, E. Capua, D. Porath, R. Naaman, Y. Paltiel, Single Nanoparticle Magnetic Spin Memristor. Small. 14, 1801249 (2018).

J. M. Abendroth, N. Nakatsuka, M. Ye, D. Kim, E. E. Fullerton, A. M. Andrews, P. S. Weiss, Analyzing Spin Selectivity in DNA-Mediated Charge Transfer via Fluorescence Microscopy. ACS Nano. 11, 7516-7526 (2017).

O. B. Dor, S. Yochelis, S. P. Mathew, R. Naaman, Y. Paltiel, A Chiral-Based Magnetic Memory Device without a Permanent Magnet. Nature Communications. 4, 2256 (2013).

G. Koplovitz, D. Prime, O. B. Dor, S. Yochelis, D. Rotem, D. Porath, Y. Paltiel, Magnetic Nanoplatelet-Based Spin Memory Device Operating at Ambient Temperatures. Advanced Materials. 29, 1606748 (2017).

O. Ben Dor, N. Morali, S. Yochelis, L. T. Baczewski, Y. Paltiel, Local Light-Induced Magnetization Using Nanodots and Chiral Molecules. Nano Letters. 14, 6042-6049 (2014).

M. Suda, Y. Thathong, V. Promarak, H. Kojima, M. Nakamura, T. Shiraogawa, M. Ehara, H. M. Yamamoto, Light-Driven Molecular Switch for Reconfigurable Spin Filters. Nature Communications. 10, 2455 (2019).

A. Fert, I. A. Campbell, Electrical Resistivity of Ferromagnetic Nickel and Iron based Alloys. Journal of Physics F: Metal Physics. 6, 849-871 (1976).

Hall-Effect Sensors - 2nd Edition, (available at www(dot)elsevier(dot)com/books/hall-effect-sensors/ramsden/978-0-7506-7934-3).

S. P. Adhikari, M. P. Sah, H. Kim, L. O. Chua, Three Fingerprints of Memristor. IEEE Transactions on Circuits and Systems I: Regular Papers. 60, 3008-3021 (2013).

Although the invention has been described in conjunction with specific embodiments thereof, it is evident that many alternatives, modifications and variations will be apparent to those skilled in the art. Accordingly, it is intended to embrace all such alternatives, modifications and variations that are defined by the subject-matter of the claims.

## Claims

1. A spin-selective conduction structure (250), comprising a crystal (252) having a monolayer (254) of metal atoms (256) between two layers (258, 260) of chiral organic molecules (262), wherein each metal atom is coupled to two chiral organic molecules, one at each layer, and wherein a chirality of organic molecules in one of said two layers is the same as a chirality of organic molecules in a another one of said two layers.

2. The spin-selective conduction structure of claim 1, wherein a chirality of all of the organic molecules in each layer is the same.

3. The spin-selective conduction structure according to any of claims 1 and 2, wherein said crystal is arranged as a stack comprising a plurality of monolayers of said metal atoms, each monolayer being between two layers of said chiral organic molecules.

4. The spin-selective conduction structure according to claim 3, wherein a thickness of said stack, perpendicular to said monolayer, is at least 150 nm.

5. The spin-selective conduction structure according to any of claims 1-4, wherein said metal atoms comprise atoms selected from the group consisting of copper atoms, cobalt atoms, nickel atoms, and platinum atoms.

6. The spin-selective conduction structure according to any of claims 1-5, being **characterized by** spin-polarization of at least 20%.

7. The spin-selective conduction structure according to any of claims 1-6, wherein said chiral organic molecules comprise chiral aromatic molecules.

8. The spin-selective conduction structure according to any of claims 1-7, wherein said crystal is noncentrosymmetric and is **characterized by** a space group $P2_1$.

9. The spin-selective conduction structure according to any of claims 1-7, wherein said crystal is noncentrosymmetric and is **characterized by** a space group P1.

10. The spin-selective conduction structure according to any of claims 1-9, wherein said chiral organic molecules comprise chiral amino acid molecules.

11. The spin-selective conduction structure according to claim 10, wherein amino and carboxylic acid moieties of said amino acid molecules are ligands forming said coupling.

12. The spin-selective conduction structure according to any of claims 1-6 wherein said chiral organic molecules comprise chiral metabolites.

13. The spin-selective conduction structure according to any of claims 1-12, comprising a semiconductor substrate (264), wherein one of said layers of chiral organic molecules is deposited on said semiconductor substrate.

14. A spintronic circuit (300), comprising the spin-selective conduction structure according to any of claims 1-13.

15. The spintronic circuit according to claim 14, being incorporated in a device selected from the group consisting of a magnetic field sensor, a memristor, a magnetic memory device, a spintronic transistor, a spin filter device, a spin valve, a spin switch, a spin-polarized light emitting diode, a quantum computer, and a data reading head for reading data from magnetic storage medium.

**Patentansprüche**

1. Spin-selektive Leitungsstruktur (250) umfassend einen Kristall (252) mit einer Monoschicht (254) aus Metallatomen (256) zwischen zwei Schichten (258, 260) chiraler organischer Moleküle (262), wobei jedes Metallatom an zwei chirale organische Moleküle gekoppelt ist, eines in jeder Schicht, und wobei eine Chiralität organischer Moleküle in einer der beiden Schichten die gleiche ist wie eine Chiralität organischer Moleküle in einer anderen der beiden Schichten.

2. Spin-selektive Leitungsstruktur nach Anspruch 1, wobei eine Chiralität aller organischer Moleküle in jeder Schicht gleich ist.

3. Spin-selektive Leitungsstruktur nach einem der Ansprüche 1 und 2, wobei der Kristall als ein Stapel angeordnet ist, der eine Vielzahl von Monoschichten der besagten Metallatome umfasst, wobei sich jede Monoschicht zwischen zwei Schichten der besagten chiralen organischen Moleküle befindet.

4. Spin-selektive Leitungsstruktur nach Anspruch 3, wobei eine Dicke des besagten Stapels senkrecht zur besagten Monoschicht, mindestens 150 nm beträgt.

5. Spin-selektive Leitungsstruktur nach einem der Ansprüche 1-4, wobei die besagten Metallatome Atome ausgewählt aus der Gruppe bestehend aus Kupferatomen, Kobaltatomen, Nickelatomen und Platinatomen umfassen.

6. Spin-selektive Leitungsstruktur nach einem der Ansprüche 1-5, **gekennzeichnet durch** eine Spinpolarisation von mindestens 20%.

7. Spin-selektive Leitungsstruktur nach einem der Ansprüche 1-6, wobei die besagten chiralen organischen Moleküle chirale aromatische Moleküle umfassen.

8. Spin-selektive Leitungsstruktur nach einem der Ansprüche 1-7, wobei der besagte Kristall nicht-zentrosymmetrisch ist und durch eine Raumgruppe $P2_1$ gekennzeichnet ist.

9. Spin-selektive Leitungsstruktur nach einem der Ansprüche 1-7, wobei der besagte Kristall nicht-zentrosymmetrisch ist und durch eine Raumgruppe P1 gekennzeichnet ist.

10. Spin-selektive Leitungsstruktur nach einem der Ansprüche 1-9, wobei die besagten chiralen organischen Moleküle chirale Aminosäuremoleküle umfassen.

11. Spin-selektive Leitungsstruktur nach Anspruch 10, wobei Amino- und Carbonsäureteile der besagten Aminosäuremoleküle Liganden sind, die die Kopplung bilden.

12. Spin-selektive Leitungsstruktur nach einem der Ansprüche 1-6, wobei die besagten chiralen organischen Moleküle chirale Metaboliten umfassen.

13. Spin-selektive Leitungsstruktur nach einem der Ansprüche 1-12, umfassend ein Halbleitersubstrat (264), wobei eine der besagten Schichten aus chiralen organischen Molekülen auf dem besagten Halbleitersubstrat abgeschieden ist.

**14.** Spintronische Schaltung (300) umfassend die spin-selektive Leitungsstruktur nach einem der Ansprüche 1-13.

**15.** Spintronische Schaltung nach Anspruch 14, die in eine Vorrichtung eingebaut ist, die aus der Gruppe bestehend aus einem Magnetfeldsensor, einem Memristor, einer magnetischen Speichervorrichtung, einem spintronischen Transistor, einer Spinfiltervorrichtung, einem Spinventil, einem Spinschalter, einer spinpolarisierten Leuchtdiode, einem Quantencomputer und einem Datenlesekopf zum Lesen von Daten aus einem magnetischen Speichermedium ausgewählt ist.


**Revendications**

**1.** Structure de conduction sélective de spin (250) comprenant un cristal (252) ayant une monocouche (254) d'atomes métalliques (256) entre deux couches (258, 260) de molécules organiques chirales (262), dans laquelle chaque atome métallique est couplé à deux molécules organiques chirales, une dans chaque couche, et dans laquelle une chiralité de molécules organiques dans l'une desdites deux couches est la même qu'une chiralité de molécules organiques dans une autre desdites deux couches.

**2.** Structure de conduction sélective de spin selon la revendication 1, dans laquelle une chiralité de toutes les molécules organiques dans chaque couche est la même.

**3.** Structure de conduction sélective de spin selon l'une quelconque des revendications 1 et 2, dans laquelle ledit cristal est disposé en tant que pile comprenant une pluralité de monocouches desdits atomes métalliques, chaque monocouche étant entre deux couches desdites molécules organiques chirales.

**4.** Structure de conduction sélective de spin selon la revendication 3, dans laquelle une épaisseur de ladite pile, perpendiculaire à ladite monocouche, est d'au moins 150 nm.

**5.** Structure de conduction sélective de spin selon l'une quelconque des revendications 1 à 4, dans laquelle lesdits atomes métalliques comprennent des atomes choisis dans le groupe constitué par des atomes de cuivre, des atomes de cobalt, des atomes de nickel et des atomes de platine.

**6.** Structure de conduction sélective de spin selon l'une quelconque des revendications 1 à 5, **caractérisée par** une polarisation de spin d'au moins 20 %.

**7.** Structure de conduction sélective de spin selon l'une quelconque des revendications 1 à 6, dans laquelle lesdites molécules organiques chirales comprennent des molécules aromatiques chirales.

**8.** Structure de conduction sélective de spin selon l'une quelconque des revendications 1 à 7, dans laquelle ledit cristal est non centrosymétrique et est **caractérisé par** un groupe spatial $P2_1$.

**9.** Structure de conduction sélective de spin selon l'une quelconque des revendications 1 à 7, dans laquelle ledit cristal est non centrosymétrique et est **caractérisé par** un groupe spatial P1.

**10.** Structure de conduction sélective de spin selon l'une quelconque des revendications 1 à 9, dans laquelle lesdites molécules organiques chirales comprennent des molécules d'acides aminés chirales.

**11.** Structure de conduction sélective de spin selon la revendication 10, dans laquelle des fractions amino et acide carboxylique desdites molécules d'acides aminés sont des ligands formant ledit couplage.

**12.** Structure de conduction sélective de spin selon l'une quelconque des revendications 1 à 6, dans laquelle lesdites molécules organiques chirales comprennent des métabolites chiraux.

**13.** Structure de conduction sélective de spin selon l'une quelconque des revendications 1 à 12, comprenant un substrat semi-conducteur (264), dans laquelle l'une desdites couches de molécules organiques chirales est déposée sur ledit substrat semi-conducteur.

**14.** Circuit spintronique (300) comprenant la structure de conduction sélective de spin selon l'une quelconque des revendications 1 à 13.

15. Circuit spintronique selon la revendication 14, qui est incorporé dans un dispositif choisi dans le groupe constitué par un capteur de champ magnétique, un memristor, un dispositif de mémoire magnétique, un transistor spintronique, un dispositif de filtre de spin, une valve de spin, un commutateur de spin, une diode électroluminescente polarisée en spin, un ordinateur quantique et une tête de lecture de données pour lire des données à partir d'un support de stockage magnétique.

FIG. 1

FIG. 2A          FIG. 2B          FIG. 2C          FIG. 2D

FIG. 2E          FIG. 2F          FIG. 2G          FIG. 2H

EP 4 118 692 B1

L-Phe-Cu                    D-Phe-Cu

FIG. 2I

FIG. 2J

FIG. 3A

FIG. 3B

FIG. 4A

FIG. 4B

FIG. 4C

FIG. 4D

FIG. 4E

FIG. 4F

FIG. 4G

FIG. 4H

FIG. 4I

FIG. 4J

FIG. 5

FIG. 6A

FIG. 6B

FIG. 6C

FIG. 6D

FIG. 6E

FIG. 6F

FIG. 7A

FIG. 7B

FIG. 7C

FIG. 7D

FIG. 8A

FIG. 8B

FIG. 8C

## FIG. 9A

(A) 2 K < T < 100 K

$y = 2.510x + 0.922$
$R^2 = 0.999$
$\theta = -0.36 \text{ K}$

## FIG. 9B

(B) 100 K < T < 300 K

$y = 2.531x - 4.311$
$R^2 = 0.999$
$\theta = +1.70 \text{ K}$

## FIG. 9C

(C) 200 K < T < 300 K

$y = 2.588x - 18.487$
$R^2 = 0.999$
$\theta = +7.14 \text{ K}$

## FIG. 9D

(D) 220 K < T < 300 K

$y = 2.607x - 23.695$
$R^2 = 0.999$
$\theta = +9.08 \text{ K}$

FIG. 10

FIG. 11

$$R_A = V_{43}/I_{12}$$

FIG. 12A

$$R_B = V_{14}/I_{23}$$

FIG. 12B

FIG. 13A

FIG. 13B                    FIG. 13C

FIG. 14A

FIG. 14B

FIG. 14C

FIG. 14D

FIG. 15A

FIG. 15B

FIG. 15C

FIG. 15D

FIG. 16A

FIG. 16B

FIG. 17A

FIG. 17B

FIG. 18A

FIG. 18B

FIG. 18C

FIG. 18D

FIG. 19A

FIG. 19B

FIG. 19C

FIG. 19D

FIG. 19E

FIG. 19F

FIG. 20A

FIG. 20B

FIG. 20C

FIG. 20D

FIG. 20E

FIG. 20F

FIG. 20G

FIG. 20H

FIG. 20I

FIG. 20J

FIG. 21A

FIG. 21B

FIG. 21C

FIG. 21D

FIG. 21E

FIG. 22A

FIG. 22B

FIG. 22C

FIG. 22D

FIG. 22E

FIG. 22F

FIG. 23A

FIG. 23B

FIG. 23C

FIG. 23D

FIG. 23E

FIG. 23F

FIG. 24A

FIG. 24B

FIG. 24C

FIG. 25

FIG. 26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 62986700

- US 9391285 B

### Non-patent literature cited in the description

- **MILLER**. Organic- and Molecule-Based Magnets. *Mater. Today*, 2014, vol. 17, 224-235
- **BOGANI et al.** Molecular Spintronics Using Single-Molecule Magnets. *Nat. Mater*, 2008, vol. 7, 179-186
- **SESSOLI**. Magnetic Molecules Back in the Race. *Nature*, 2017, vol. 548, 400-401
- **ALEXANDROPOULOS et al.** *Chem. Sci.*, 2019, vol. 10, 1626-1633
- **OSHIO et al.** Superparamagnetic Behavior in an Alkoxo-Bridged Iron(II) Cube. *J. Am. Chem. Soc.*, 2000, vol. 122, 12602-12603
- **GOODWIN et al.** Molecular Magnetic Hysteresis at 60 K in Dysprosocenium. *Nature*, 2017, vol. 548, 439-4421
- **CORONADO et al.** Synthesis, Chirality, and Magnetic Properties of Bimetallic Cyanide-Bridged Two-Dimensional Ferromagnets. *Chem. Mater*, 2006, vol. 18, 2670-2681
- **SHIOMI et al.** An Enantiopair of Organic Ferromagnet Crystals Based on Helical Molecular Packing of Achiral Organic Radicals.. *J. Phys. Chem. Lett.*, 2011, vol. 2, 3036-3039
- **DHARA et al.** Possible Room-Temperature Ferromagnetism in Self-Assembled Ensembles of Paramagnetic and Diamagnetic Molecular Semiconductors. *J. Phys. Chem. Lett.*, 2016, vol. 7, 4988-4995
- **LU et al.** Spin-dependent charge transport through 2D chiral hybrid lead-iodide perovskites.. *Science Advances*, 2019, vol. 5, eaay0571
- **PUNZI et al.** Metal chelates anchored to poly-L-peptides and linear D,L-$\alpha$-peptides with promising nanotechnological applications. *Nanotechnology*, 2012, vol. 23, 395703
- **ZHANG et al.** Low-magnetic-field controlled magnetodielectric coupling at room temperature in a chiral layered diphenylalanine-based 1D-coordination-polymer. *Journal of Physics D: Applied Physics*, 2020, vol. 53, 15LT01
- **DHARA et al.** Diamagnetic Molecules Exhibiting Room-Temperature Ferromagnetism in Supramolecular Aggregates. *J. Phys. Chem. C*, 2017, vol. 121, 12159-12167

- **MILLER, J. S.** Organic- and Molecule-Based Magnets. *Mat. Today*, 2014, vol. 17, 224-235
- **BOGANI, L.** ; **WERNSDORFER, W.** Molecular Spintronics Using Single-Molecule Magnets. *Nat. Mat.*, 2008, vol. 7, 179-186
- **SESSOLI, R.** Magnetic Molecules Back in the Race. *Nature*, 2017, vol. 548, 400-401
- **ALEXANDROPOULOS, D. I.** ; **VIGNESH, K. R.** ; **STAMATATOS, T. C.** ; **DUNBAR, K. R.** Rare "Janus"-Faced {FeII7} Single-Molecule Magnet Exhibiting Intramolecular Ferromagnetic Interactions.. *Chem. Sci.*, 2019, vol. 10, 1626-1633
- **OSHIO, H.** ; **HOSHINO, N** ; **ITO, T.** Superparamagnetic Behavior in an Alkoxo-Bridged Iron(II) Cube. *J. Am. Chem. Soc.*, 2000, vol. 122, 12602-12603
- **GOODWIN, C. A. P.** ; **ORTU, F.** ; **RETA, D.** ; **CHILTON, N. F.** ; **MILLS, D. P.** Molecular Magnetic Hysteresis at 60 Kelvin in Dysprosocenium.. *Nature*, 2017, vol. 548, 439-442
- **CORONADO, E.** ; **GÓMEZ-GARCÍA, C. J.** ; **NUEZ, A.** ; **ROMERO, F. M.** ; **WAERENBORGH, J. C.** Synthesis, Chirality, and Magnetic Properties of Bimetallic Cyanide-Bridged Two-Dimensional Ferromagnets.. *Chem. Mater*, 2006, vol. 18, 2670-2681
- **SHIOMI, D.** ; **KANZAKI, Y** ; **OKADA, S.** ; **ARIMA, R.** ; **MIYAZAKI, Y.** ; **INABA, A.** ; **TANAKA, R.** ; **SATO, K.** ; **TAKU, T.** An Enantiopair of Organic Ferromagnet Crystals Based on Helical Molecular Packing of Achiral Organic Radicals. *J. Phys. Chem. Lett.*, 2011, vol. 2, 3036-3039
- **DHARA, B** ; **TARAFDER, K.** ; **JHA, P. K.** ; **PANJA, S. N** ; **NAIR, S.** ; **OPPENEER, P. M.** ; **BALLAV, N.** Possible Room-Temperature Ferromagnetism in Self-Assembled Ensembles of Paramagnetic and Diamagnetic Molecular Semiconductors. *J. Phys. Chem. Lett.*, 2016, vol. 24, 4988-4995
- **DHARA, B.** ; **JHA, P. K.** ; **GUPTA, K.** ; **BIND, V. K.** ; **BALLAV, N**. Diamagnetic Molecules Exhibiting Room-Temperature Ferromagnetism in Supramolecular Aggregates. *J. Phys. Chem. C*, 2017, vol. 121, 12159-12167

- **YANG, B.** ; **XIAO, Z.** ; **YUAN, Y** ; **JAYARAMAN, T. V.** ; **SHIELD, J. E.** ; **SKOMSKI, R.** ; **HUANG, J.** Room-Temperature Organic Ferromagnetism in the Crystalline Poly(3-hexylthiophene): Phenyl-C61-Butyric Acid Methyl Ester Blend Film. *Polymer*, 2013, vol. 54, 490-494

- **MILLER, J. S.** ; **EPSTEIN, A. J.** ; **REIFF, W. M.** Molecular/Organic Ferromagnets. *Science*, 1988, vol. 240, 40-47

- **KINOSHITA, M.** Ferromagnetism of Organic Radical Crystals. *Jpn. J. Appl. Phys.*, 1994, vol. 33, 5718-5733

- **PHAN, H** ; **HERNG, T. S.** ; **WANG, D.** ; **LI, X.** ; **ZENG, W.** ; **DING, J.** ; **LOH, K. P.** ; **WEE, A. T. S.** ; **WU, J.** Room-Temperature Magnets Based on 1,3,5-Triazine-Linked Porous Organic Radical Frameworks.. *Chem*, 2019, vol. 5, 1223-1234

- **NAAMAN, R.** ; **PALTIEL, Y.** ; **WALDECK, D. H.** Chiral Molecules and the Electron Spin. *Nat. Rev. Chem.*, 2019, vol. 3, 250-260

- **GÖHLER, B.** ; **HAMELBECK, V.** ; **MARKUS, T. Z.** ; **KETTNER, M.** ; **HANNE, G. F.** ; **VAGER, Z.** ; **NAAMAN, R.** ; **ZACHARIAS, H.** Spin Selectivity in Electron Transmission Through Self-Assembled Monolayers of Double-Stranded DNA. *Science*, 2011, vol. 331, 894-897

- **XIE, Z.** ; **MARKUS, T. Z.** ; **COHEN, S. R** ; **VAGER, Z.** ; **GUTIERREZ, R.** ; **NAAMAN, R.** Spin Specific Electron Conduction through DNA Oligomers.. *Nano Lett*, 2011, vol. 11, 4652-4655

- **MISHRA, D** ; **MARKUS, T. Z.** ; **NAAMAN, R.** ; **KETTNER, M.** ; **GÖHLER, B.** ; **ZACHARIAS, H** ; **FRIEDMAN, N.** ; **SHEVES, M.** ; **FONTANESI, C.** Spin-Dependent Electron Transmission Through Bacteriorhodopsin Embedded in Purple Membrane. *Proc. Natl. Acad. Sci. U. S. A.*, 2013, vol. 110, 14872-14876

- **ECKSHTAIN-LEVI, M.** ; **CAPUA, E.** ; **REFAELY-ABRAMSON, S.** ; **SARKAR, S.** ; **GAVRILOV, Y.** ; **MATHEW, S. P.** ; **PALTIEL, Y.** ; **LEVY, Y.** ; **KRONIK, L.** ; **NAAMAN, R.** Cold Denaturation Induces Inversion of Dipole and Spin Transfer in Chiral Peptide Monolayers. *Nat. Commun*, 2016, vol. 7, 10744

- **ZWANG, T. J.** ; **HÜRLIMANN, S.** ; **HILL, M. G.** ; **BARTON, J. K.** Helix-Dependent Spin Filtering through the DNA Duplex.. *J. Am. Chem. Soc.*, 2016, vol. 138, 15551-15554

- **ABENDROTH, J. M.** ; **CHEUNG, K. M.** ; **STEMER, D. M.** ; **EL HADRI, M. S.** ; **ZHAO, C** ; **FULLERTON, E. E.** ; **WEISS, P. S.** Spin-Dependent Ionization of Chiral Molecular Films. *J. Am. Chem. Soc.*, 2019, vol. 141, 3863-3874

- **ARAGONÈS, A. C** ; **MEDINA, E** ; **FERRER-HUERTA, M.** ; **GIMENO, N.** ; **TEIXIDÓ, M.** ; **PALMA, J. L.** ; **TAO, N.** ; **UGALDE, J. M.** ; **GIRALT, E.** ; **DÍEZ-PÉREZ, I.** Measuring the Spin-Polarization Power of a Single Chiral Molecule. *Small*, 2017, vol. 13, 1602519

- **MISHRA, S.** ; **PIRBADIAN, S.** ; **MONDAL, A. K.** ; **EL-NAGGAR, M. Y.** ; **NAAMAN, R.** Spin-Dependent Electron Transport through Bacterial Cell Surface Multiheme Electron Conduits. *J. Am. Chem. Soc.*, 2019, vol. 141, 19198-19202

- **LU, H.** ; **WANG, J.** ; **XIAO, C.** ; **PAN, X.** ; **CHEN, X.** ; **BRUNECKY, R.** ; **BERRY, J. J** ; **ZHU, K.** ; **BEARD, M. C.** ; **VARDENY, Z. V.** Spin-Dependent Charge Transport through 2D Chiral Hybrid Lead-Iodide Perovskites.. *Sci. Adv.*, 2019, vol. 5, eaay0571

- **NGUYEN, V.** ; **ZHU, R.** ; **JENKINS, K.** ; **YANG, R.** Self-Assembly of Diphenylalanine Peptide with Controlled Polarization for Power Generation. *Nat. Comm.*, 2016, vol. 7, 13566

- **YUAN, H.** ; **HAN, P.** ; **TAO, K.** ; **LIU, S.** ; **GAZIT, E.** ; **YANG, R.** Piezoelectric Peptide and Metabolite Materials. *Research*, 2019, 9025939

- **SPALDIN, N. A.** ; **RAMESH, R.** Advances in Magnetoelectric Multiferroics. *Nat. Mat.*, 2019, vol. 18, 203-212

- **SHABBIR, B.** ; **NADEEM, M.** ; **DAI, Z.** ; **FUHRER, M** ; **XUE, Q-K.** ; **WANG, X.** ; **BAO, Q.** Long Range Intrinsic Ferromagnetism in Two Dimensional Materials and Dissipationless Future Technologies.. *Appl. Phys. Rev.*, 2018, vol. 5, 041105

- **KRAVCHENKO, S. V** ; **KRAVCHENKO, G. V.** ; **FURNEAUX, J. E.** ; **PUDALOV, V. M** ; **D'IORIO, M.** Possible Metal Insulator Transition at B = 0 in Two Dimensions. *Phys. Rev. B*, 1994, vol. 50, 8039-8042

- **HANEIN, Y.** ; **NENADOVIC, N.** ; **SHAHAR, D.** ; **SHTRIKMAN, H.** ; **YOON, J.** ; **LI, C. C.** ; **TSUI, D. C.** Linking Insulator-to-Metal Transitions at Zero and Finite Magnetic Fields. *Nature*, 1999, vol. 400, 735-737

- **RASTOGI, A.** ; **BRAHLEK, M.** ; **OK, J. M.** ; **LIAO, Z.** ; **SOHN, C.** ; **FELDMAN, S.** ; **LEE, H. N.** Metal-Insulator Transition in (111) SrRuO3 Ultrathin Films. *APL Mater*, 2019, vol. 7 (111), 091106

- **KIRAN, V.** ; **COHEN, S. R.** ; **NAAMAN, R.** Structure Dependent Spin Selectivity in Electron Transport Through Oligopeptides. *J. Chem. Phys*, 2017, vol. 146, 092302

- **MICHAELI, K.** ; **VARADE, V.** ; **NAAMAN, R.** ; **WALDECK, D. H.** A New Approach Towards Spintronics - Spintronics with no Magnets. *J. Phys. Condens. Matter.*, 2017, vol. 29, 103002

- **KRESSE, G.** ; **FURTHMÜLLER, J.** Efficient Iterative Schemes for ab Initio Total-Energy Calculations Using a Plane-Wave Basis Set.. *Phys. Rev. B*, 1996, vol. 54, 11169-11186

- **PERDEW, J. P.** ; **BURKE, K.** ; **ERNZERHOF, M.** Generalized Gradient Approximation Made Simple.. *Phys. Rev. Lett.*, 1996, vol. 77, 3865-3868
- **PERDEW, J. P.** ; **BURKE, K** ; **ERNZERHOF, M.** Generalized Gradient Approximation Made Simple. *Phys. Rev. Lett.*, 1997, vol. 78, 1396-1396
- **TKATCHENKO, A.** ; **SCHEFFLER, M.** Accurate Molecular Van der Waals Interactions from Ground-State Electron Density and Free-Atom Reference Data. *Phys. Rev. Lett.*, 2009, vol. 102, 073005
- **KRONIK, L.** ; **TKATCHENKO, A.** Understanding Molecular Crystals with Dispersion-Inclusive Density Functional Theory: Pairwise Corrections and Beyond. *Acc. Chem. Res*, 2014, vol. 47, 3208-3216
- **HEYD, J.** ; **SCUSERIA, G. E.** ; **ERNZERHOF, M.** Hybrid Functionals Based on a Screened Coulomb Potential.. *J. Chem. Phys*, 2003, vol. 118, 8207-8215
- **HEYD, J.** ; **SCUSERIA, G. E.** ; **ERNZERHOF, M.** Hybrid Functionals Based on a Screened Coulomb Potential. *J. Chem. Phys*, 2006, vol. 124, 219906-219906
- **MAROM, N.** ; **HOD, O** ; **SCUSERIA, G. E.** ; **KRONIK, L.** Electronic Structure of Copper Phthalocyanine: A Comparative Density Functional Theory Study. *J. Chem. Phys.*, 2008, vol. 128, 164107
- **PRATZER, M** ; **ELMERS, H. J.** Lateral Indirect Exchange Coupling in a Two-Dimensional Nanostripe Array.. *Phys. Rev. B*, 2002, vol. 66, 033402
- **ZHANG, X.** ; **ALI, N.** Entropy Change at the Ferromagnetic-Antiferromagnetic Transition in the Intermetallic Compound Ce(Fe0.8Co0.2)2.. *J. Alloys Comp.*, 1994, vol. 207/208, 300-303
- **FLIPPEN, R. B.** ; **DARNELL, F. J.** Entropy Changes of Ferromagnetic-Antiferromagnetic Transitions from Magnetic Measurements. *J. Appl. Phys.*, 1963, vol. 34, 1094-1095
- **FRANSSON, J.** ; **THONIG, D.** ; **BESSARAB, P. F.** ; **BHATTACHARJEE, S.** ; **HELLSVIK, J.** ; **NORD-STRÖM, L.** Microscopic Theory for Coupled Atomistic Magnetization and Lattice Dynamics. *Phys. Rev. Mat.*, 2017, vol. 1, 074404
- **NOMURA, T.** ; **ZHANG, X.-X.** ; **ZHERLITSYN, S.** ; **WOSNITZA, J.** ; **TOKURA, Y.** ; **NAGAOSA, N** ; **SEKI, S**. Phonon Magnetochiral Effect.. *Phys. Rev. Lett.*, 2019, vol. 122, 145901
- **KORENEV, V. L** ; **SALEWSKI, M.** ; **AKIMOV, I. A.** ; **SAPEGA, V. F.** ; **LANGER, L.** ; **KALITUKHA, I. V.** ; **DEBUS, J.** ; **DZHIOEV, R. I.** ; **YAKOVLEV, D. R.** ; **MÜLLER, D.** Long-Range p-d Exchange Interaction in a Ferromagnet-Semiconductor Hybrid Structure. *Nat. Phys.*, 2016, vol. 12, 85-91
- **KUMAR, A.** ; **CAPUA, E.** ; **KESHARWANI, M. K.** ; **MARTIN, J. M. L.** ; **SITBON, E.** ; **WALDECK, D. H.** ; **NAAMAN, R.** Chirality-Induced Spin Polarization Places Symmetry Constraints on Biomolecular Interactions.. *PNAS*, 2017, vol. 114, 2474-2478
- **MACRAE, C. F.** ; **EDGINGTON, P. R.** ; **MCCABE, P.** ; **PIDCOCK, E.** ; **SHIELDS, G. P.** ; **TAYLOR, R.** ; **TOWLER, M.** ; **VAN DE STREEK, J.** Mercury: Visualization and Analysis of Crystal Structures. *J. Appl. Cryst*, 2006, vol. 39, 453-457
- **DAMJANOVIC, D.** Ferroelectric, Dielectric and Piezoelectric Properties of Ferroelectric Thin Films and Ceramics.. *Rep. Prog. Phys*, 1998, vol. 61, 1267-1324
- **BAR-CHAIM, N.** ; **BRUNSTEIN, M** ; **GRUNBERG, J.** ; **SEIDMAN, A.** Electric Field Dependence of the Dielectric Constant of PZT Ferroelectric Ceramics. *J. Appl. Phys*, 1974, vol. 45, 2398-2405
- **WOUTERS, D. J.** ; **WILLEMS, G** ; **LEE, E. G.** ; **MAES, H. E.** Elucidation of the Switching Processes in Tetragonal pzt by Hysteresis Loop and Impedance Analysis. *Integrated Ferroelectrics*, 1997, vol. 15, 79-87
- **MONKHORST, H. J.** ; **PACK, J. D.** Special Points for Brillouin-Zone Integrations. *Phys. Rev. B*, 1976, vol. 13, 5188-5192
- **HEYD, J.** ; **PERALTA, J. E.** ; **SCUSERIA, G. E.** ; **MARTIN, R. L.** Energy Band Gaps and Lattice Parameters Evaluated with the Heyd-Scuseria-Ernzerhof Screened Hybrid Functional. *J. Chem. Phys.*, 2005, vol. 123, 174101
- **MOMMA, K.** ; **IZUMI, F.** VESTA 3 for Three-Dimensional Visualization of Crystal, Volumetric and Morphology Data.. *J. Appl. Cryst*, 2011, vol. 44, 1272-1276
- **M. O'NEILL** ; **S. M. KELLY**. Ordered Materials for Organic Electronics and Photonics. *Advanced Materials*, 2011, vol. 23, 566-584
- **S. R. FORREST** ; **M. E. THOMPSON**. Introduction: Organic Electronics and Optoelectronics. *Chem. Rev.*, 2007, vol. 107, 923-925
- **T. AIDA** ; **E. W. MEIJER** ; **S. I. STUPP**. Functional Supramolecular Polymers. *Science*, 2012, vol. 335, 813-817
- **U. MITSCHKE** ; **P. BÄUERLE**. The Electroluminescence of Organic Materials. *Journal of Materials Chemistry*, 2000, vol. 10, 1471-1507
- **J.-S. PARK** ; **H. CHAE** ; **H. K. CHUNG** ; **S. I. LEE**. Thin Film Encapsulation for Flexible AM-OLED: A Review. *Semiconductor Science and Technology*, 2011, vol. 26, 034001
- **J. H. BURROUGHES** ; **D. D. C. BRADLEY** ; **A. R. BROWN** ; **R. N. MARKS** ; **K. MACKAY** ; **R. H. FRIEND** ; **P. L. BURNS** ; **A. B. HOLMES**. Light-Emitting Diodes based on Conjugated Polymers.. *Nature*, 1990, vol. 347, 539-541

- **I. VALOV** ; **M. KOZICKI**. Organic Memristors Come of Age. *Nature Materials*, 2017, vol. 16, 1170-1172
- **H. WANG** ; **F. MENG** ; **B. ZHU** ; **W. R. LEOW** ; **Y. LIU** ; **X. CHEN**. Resistive Switching Memory Devices Based on Proteins.. *Advanced Materials*, 2015, vol. 27, 7670-7676
- **W. J. M. NABER** ; **S. FAEZ** ; **W. G. VAN DER WIEL**. Organic Spintronics.. *arXiv:cond-mat/0703455*, 2007, www(dot)arxiv(dot)org/abs/cond-mat/0703455
- **D. SUN** ; **E. EHRENFREUND** ; **Z. V. VARDENY**. The First Decade of Organic Spintronics Research.. *Chemical Communications*, 2014, vol. 50, 1781-1793
- **Y. HUAI**. Spin-Transfer Torque MRAM (STT-MRAM): Challenges and Prospects.. *AAPPS Bulletin*, 2008, vol. 18, 33-40
- **J. A. KATINE** ; **E. E. FULLERTON**. Device Implications of Spin-Transfer Torques. *Journal of Magnetism and Magnetic Materials*, 2008, vol. 320, 1217-1226
- **S. BHATTI** ; **R. SBIAA** ; **A. HIROHATA** ; **H. OHNO** ; **S. FUKAMI** ; **S. N. PIRAMANAYAGAM**. Spintronics based random access memory: a review.. *Materials Today*, 2017, vol. 20, 530-548
- **A. PRAKASH** ; **H. HWANG**. Multilevel Cell Storage and Resistance Variability in Resistive Random Access Memory.. *Physical Sciences Reviews*, 2016, vol. 1, 6
- **I. VOURKAS** ; **G. C. SIRAKOULIS**. Emerging Memristor-Based Logic Circuit Design Approaches: A Review.. *IEEE Circuits and Systems Magazine*, 2016, vol. 16, 15-30
- **L. CHUA**. Memristor-The missing circuit element.. *IEEE Transactions on Circuit Theory*, 1971, vol. 18, 507-519
- **Y. HALAWANI** ; **B. MOHAMMAD** ; **D. HOMOUZ** ; **M. AL-QUTAYRI** ; **H. SALEH**. Modeling and Optimization of Memristor and STT-RAM-Based Memory for Low-Power Applications.. *IEEE Transactions on Very Large Scale Integration (VLSI) Systems*, 2016, vol. 24, 1003-1014
- **H. AL-BUSTAMI** ; **G. KOPLOVITZ** ; **D. PRIME** ; **S. YOCHELIS** ; **E. CAPUA** ; **D. PORATH** ; **R. NAAMAN** ; **Y. PALTIEL**. Single Nanoparticle Magnetic Spin Memristor. *Small*, 2018, vol. 14, 1801249
- **J. M. ABENDROTH** ; **N. NAKATSUKA** ; **M. YE** ; **D. KIM** ; **E. E. FULLERTON** ; **A. M. ANDREWS** ; **P. S. WEISS**. Analyzing Spin Selectivity in DNA-Mediated Charge Transfer via Fluorescence Microscopy.. *ACS Nano.*, 2017, vol. 11, 7516-7526
- **O. B. DOR** ; **S. YOCHELIS** ; **S. P. MATHEW** ; **R. NAAMAN** ; **Y. PALTIEL**. A Chiral-Based Magnetic Memory Device without a Permanent Magnet.. *Nature Communications*, 2013, vol. 4, 2256
- **G. KOPLOVITZ** ; **D. PRIME** ; **O. B. DOR** ; **S. YOCHELIS** ; **D. ROTEM** ; **D. PORATH** ; **Y. PALTIEL**. Magnetic Nanoplatelet-Based Spin Memory Device Operating at Ambient Temperatures.. *Advanced Materials.*, 2017, vol. 29, 1606748
- **O. BEN DOR** ; **N. MORALI** ; **S. YOCHELIS** ; **L. T. BACZEWSKI** ; **Y. PALTIEL**. Local Light-Induced Magnetization Using Nanodots and Chiral Molecules.. *Nano Letters*, 2014, vol. 14, 6042-6049
- **M. SUDA** ; **Y. THATHONG** ; **V. PROMARAK** ; **H. KOJIMA** ; **M. NAKAMURA** ; **T. SHIRAOGAWA** ; **M. EHARA** ; **H. M. YAMAMOTO**. Light-Driven Molecular Switch for Reconfigurable Spin Filters.. *Nature Communications*, 2019, vol. 10, 2455
- **A. FERT** ; **I. A. CAMPBELL**. Electrical Resistivity of Ferromagnetic Nickel and Iron based Alloys.. *Journal of Physics F: Metal Physics*, 1976, vol. 6, 849-871
- **S. P. ADHIKARI** ; **M. P. SAH** ; **H. KIM** ; **L. O. CHUA**. Three Fingerprints of Memristor. *IEEE Transactions on Circuits and Systems I: Regular Papers.*, 2013, vol. 60, 3008-3021